# EUROPEAN PATENT SPECIFICATION

(11) **EP 3 699 318 B1**
(45) Date of publication and mention of the grant of the patent: **04.09.2024**
(21) Application number: 18867782.7
(22) Date of filing: 04.10.2018
(51) Int. Cl.: C23C 14/20, C23C 14/50, C23C 14/54, C23C 14/56, C23C 16/54

(54) **CAN ROLL, LONG-SUBSTRATE PROCESSING DEVICE, AND METHOD FOR MANAGING LONG-SUBSTRATE PROCESSING DEVICE**
WALZE, VERARBEITUNGSVORRICHTUNG FÜR LANGE SUBSTRATE UND VERFAHREN ZUR VERWALTUNG EINER VERARBEITUNGSVORRICHTUNG FÜR LANGE SUBSTRATE
ROULEAU SCELLÉ, DISPOSITIF DE TRAITEMENT DE SUBSTRATS LONGS ET MÉTHODE DE MANAGEMENT D'UN DISPOSITIF DE TRAITEMENT DE SUBSTRATS LONGS

(30) Priority: 19.10.2017 JP 2017202625
(43) Date of publication of application: 26.08.2020
(73) Proprietor: Sumitomo Metal Mining Co., Ltd., Tokyo 105-8716 (JP)
(72) Inventor: OKAMI, Hideharu, Niihama-shi Ehime 792-0008 (JP)
(74) Representative: TBK
(86) International application number: PCT/JP2018/037166
(87) International publication number: WO 2019/078014

(56) References cited:
- EP-A1- 3 699 319
- WO-A1-2018/038141
- JP-A- 2012 132 081
- JP-A- 2016 079 494
- JP-A- 2017 137 543

## Description

### TECHNICAL FIELD

The present invention relates to a long substrate treatment apparatus for performing a surface treatment that applies a thermal load such as ion beam treatment or sputtering deposition on a long substrate such as a long heat-resistant resin film transferred through a vacuum chamber in a roll-to-roll manner and wrapped on the outer peripheral surface of a can roll, and relates in particular to an improvement in a can roll including a gas discharge mechanism with high cooling performance and being capable of suppressing gas leakage from the outer peripheral surface of the can roll on which a long substrate cannot be wrapped, and a long substrate treatment apparatus using this can roll.

### BACKGROUND ART

Flexible wiring substrates are used in liquid crystal panels, laptop computers, digital cameras, mobile phones, and so on. A flexible wiring substrate is fabricated from a metal film-coated heat-resistant resin film obtained by depositing a metal film on one or both surfaces of heat-resistant resin film. In recent years, wiring patterns formed on flexible wiring substrates have increasingly become finer and denser and it has become more important for metal film-coated heat-resistant resin films themselves to be flat and smooth with no wrinkles or the like.

Conventional methods of manufacturing this type of metal film-coated heat-resistant resin film have known such as: a manufacturing method in which a metal foil is attached to a heat-resistant resin film with an adhesive (referred to as the three-layer substrate manufacturing method); a manufacturing method in which a metal foil is coated with a heat-resistant resin solution and then the resin solution is dried (referred to as the casting method); and a manufacturing method in which a metal film is deposited on a heat-resistant resin film by a dry plating method (vacuum deposition method) or a combination of a dry plating method (vacuum deposition method) and a wet plating method (referred to as the metallizing method). Also, the dry plating method (vacuum deposition method) in the metallizing method includes vacuum vapor deposition methods, sputtering methods, ion plating methods, ion beam sputtering methods, and so on.

As the metallizing method, JP H02 98994 A discloses a method in which chromium is sputtered onto a polyimide insulating layer and then copper is sputtered to form a conductive layer on the polyimide insulating layer. Also, JP 3 447 070 B2 discloses a flexible circuit board material formed by sequentially laminating a first metal thin film formed by sputtering a target of a copper-nickel alloy and a second metal thin film formed by sputtering a target of copper onto a polyimide film. Note that a sputtering web coater is usually used to perform vacuum deposition on a heat-resistant resin film (substrate) such as a polyimide film.

Generally, among the vacuum deposition methods mentioned above, the sputtering methods have been said to provide better bond but apply a larger thermal load to the heat-resistant resin film than the vacuum vapor deposition methods. Moreover, it has also been known that applying a large thermal load to the heat-resistant resin film during the deposition makes the film more prone to formation of wrinkles. To prevent the formation of the wrinkles, sputtering web coaters as apparatuses for manufacturing a metal film-coated heat-resistant resin film are equipped with a can roll having a cooling function, and employ an method in which this can roll is rotationally driven while a heat-resistant resin film transferred in a roll-to-roll manner is wrapped on a transfer path defined on the outer peripheral surface of the can roll, to thereby cool the heat-resistant resin film from its back surface during the sputtering process.

For example, JP S62 247073 A discloses an unwinding-winding type (roll-to-roll type) vacuum sputtering apparatus as an example of the sputtering web coaters. This unwinding-winding type vacuum sputtering apparatus includes a cooling roll that serves as the above can roll, and performs control that brings a film into tight contact with the cooling roll by using an additional sub roll provided at least on the film infeed side or the film outfeed side of the cooling roll.

However, as described in "Vacuum Heat Transfer Models for Web Substrates: Review of Theory and Experimental Heat Transfer Data", 2000 Society of Vacuum Coaters, 43rd Annual Technical Conference Proceeding, Denver, April 15-20, 2000, p.335, the outer peripheral surface of the can roll is not flat when viewed microscopically. Thus, between the can roll and the film transferred in tight contact with its outer peripheral surface, gap regions (clearances) are present which separate them with a vacuum space therebetween. Accordingly, it cannot be said that the heat in the film generated during sputtering or vapor deposition is actually efficiently transferred to the can roll from the film. This has been a cause of the formation of film wrinkles.

To solve this, a technique has been proposed in which a gas is introduced into the gap regions between the outer peripheral surface of the can roll and the film from the can roll side to thereby make the thermal conductivity of the gap regions higher than the vacuum.

Further, as specific methods of introducing a gas into the gap regions from the can roll side, for example WO 2005/001157 A2 discloses a technique in which many small holes are provided in the outer peripheral surface of a can roll as gas discharge ports, and US 3 414 048 A discloses a technique in which grooves are provided in the outer peripheral surface of a can roll as gas discharge ports. Moreover, a method in which a can roll itself is made from a porous body and the small holes in the porous body itself are used as gas discharge ports.

Meanwhile, in methods in which small holes, grooves, or the like are provided in the outer peripheral surface of a can roll as gas discharge ports, the resistance at the gas discharge ports are lower in the region of the outer peripheral surface of the can roll where the film is not wrapped (non-wrapped portion region) than in the region where the film is wrapped (wrapped portion region). This sometimes leads to a situation where the gas supplied to the can roll is mostly discharged to the space in the vacuum chamber from the gas discharge ports in the non-wrapped portion region, which results in a failure to supply the amount of gas that is supposed to be introduced into the gap regions between the outer peripheral surface of the can roll and the film wrapped thereon, and thus makes it impossible to achieve the thermal conductivity enhancing effect mentioned above.

To solve this problem, methods have been proposed such as: a method in which valves that project from the outer peripheral surface of a can roll are provided in gas discharge ports, and the gas discharge ports are opened by pressing a film surface against the respective valves (see US 3 414 048 A); and a method in which a cover is attached to the region of the outer peripheral surface of a can roll where a film is not wrapped, starting from an outfeed point at which the film is outfed and ending at an infeed point at which the film is infed (the non-wrapped portion region of the outer peripheral surface of the can roll) to thereby prevent discharge of a gas from the non-wrapped portion region to the space in the vacuum chamber and thus efficiently introduce the gas into the gap regions between the outer peripheral surface of the can roll and the film surface (see WO 2002/070778 A1).

However, with the method of US 3 414 048 A, in which the gas discharge ports are opened by pressing the film surface against the respective valves projecting from the outer peripheral surface of the can roll, there is a possibility that the film surface is slightly damaged or dented by its contact with the valves. Thus, it is difficult to employ the method of US 3 414 048 A for manufacturing flexible wiring substrates for electronic devices that are required to have high quality. Also, with the method of WO 2002/070778 A1, in which a cover is attached to the region of the outer peripheral surface of a can roll where a film is not wrapped (non-wrapped portion region), gas is likely to leak from the clearance between the cover and the outer peripheral surface of the can roll in a treatment apparatus that performs deposition under high vacuum. Thus, like the method of US 3 414 048 A, it is difficult to employ the method of WO 2002/070778 A1.

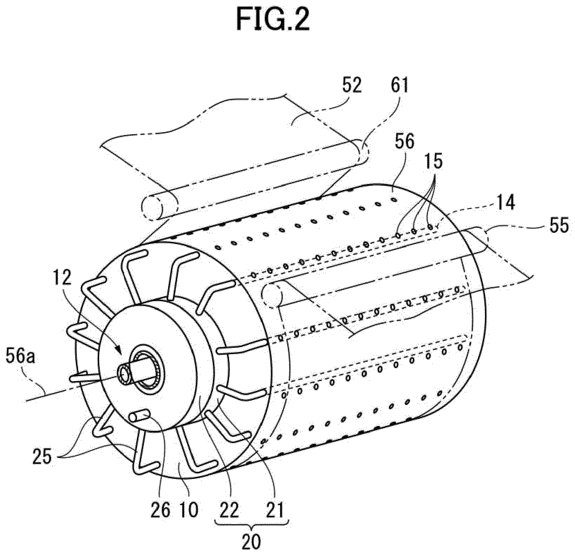

Under these technical circumstances, the present inventor has already proposed a can roll with a structure that does not supply a gas to the outer peripheral surface of the can roll where a film is not wrapped to thereby prevent discharge of the gas from the non-wrapped portion region (see JP 2012 132081 A). Specifically, as illustrated in FIG. 2, this can roll is a can roll 56 provided with a plurality of gas introduction channels 14 in a thick portion of the can roll 56, many gas discharge holes 15 are provided in each gas introduction channel 14, and the can roll 56 is controlled so as to supply a gas from outside the vacuum chamber selectively to the gas introduction channels 14 through a rotary joint 20 described below. Here, as illustrated in FIG. 2, the rotary joint 20 includes a fixed ring unit 22 and a rotary ring unit 21, and there are a can roll fabricated such that each unit's gas control sliding contact surface is formed perpendicularly to a center axis 56a of the can roll 56, and a can roll fabricated such that each unit's gas control sliding contact surface is formed in parallel to the center axis 56a.

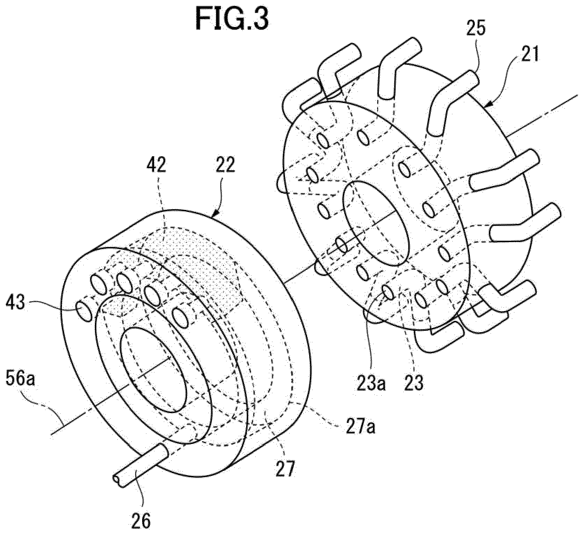

Further, as illustrated in FIGS. 3 to 5, the rotary ring unit 21 of the can roll whose fixed ring unit 22 and rotary ring unit 21 include gas control sliding contact surfaces formed perpendicularly to the center axis 56a of the can roll 56 includes a plurality of gas supply channels 23 that communicate with a plurality of gas introduction channels 14 through connection pipes 25, respectively. Moreover, each of the plurality of gas supply channels 23 includes a revolving opening portion 23a at the gas control sliding contact surface, the revolving opening portion 23a opening at an angular position corresponding to the angular position, on the outer peripheral surface of the can roll 56, of the gas introduction channel 14 communicating with the gas supply channel 23 through the corresponding gas supply channel 25 (i.e., an angular position substantially the same as the angular position on the outer peripheral surface of the can roll 56). On the other hand, the fixed ring unit 22 includes a gas distribution channel 27 formed by an annular recessed groove 27a, including a fixed closed portion and a fixed opening portion, and communicating with a supply pipe 26 outside the vacuum chamber, the annular recessed groove 27a being provided in the gas control sliding contact surface of the fixed ring unit so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. The fixed opening portion opens within an angular range in a region on the gas control sliding contact surface of the fixed ring unit 22 which the revolving opening portions 23a of the rotary ring unit 21 face, the angular range being a range within which a film (long substrate) 52 is wrapped. Note that reference sign 43 in FIGS. 3 to 5 denotes a packing attachment member.

Further, as illustrated in FIG. 3, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside a vacuum chamber 50 is not supplied to the gas supply channels 23. Hence, the gas is not discharged from the gas discharge holes 15 in the outer peripheral surface of the can roll 56. Also, as illustrated in FIG. 3, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

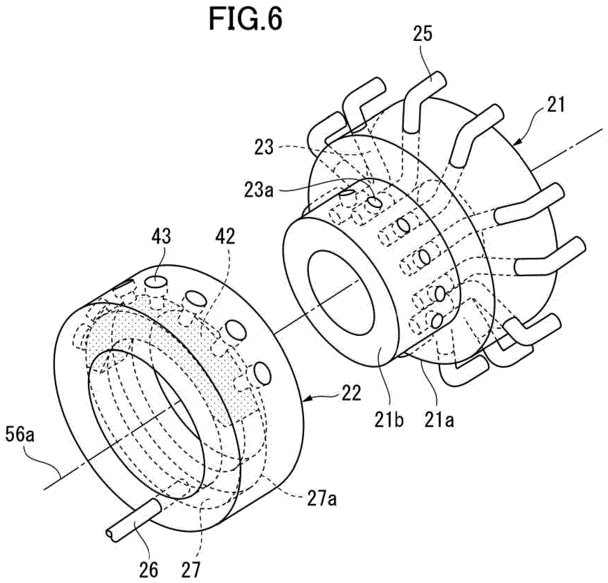

On the other hand, as illustrated in FIGS. 6 to 8, the rotary joint 20 whose fixed ring unit 22 and rotary ring unit 21 include gas control sliding contact surfaces formed in parallel to the center axis 56a of the can roll 56 includes a rotary ring unit 21 having a T-shaped cross section and including a cylindrical base part 21a and a cylindrical protruding part 21b provided coaxially with the can roll 56, and a cylindrical fixed ring unit 22 in which the cylindrical protruding part 21b of the rotary ring unit 21 is fitted. Further, the rotary ring unit 21 includes a plurality of gas supply channels 23 that communicate with a plurality of gas introduction channels 14 through connection pipes 25, respectively. Moreover, each gas supply channel 23 includes a revolving opening portion 23a at the gas control sliding contact surface of the cylindrical protruding part 21b, the revolving opening portion 23a opening at an angular position corresponding to the angular position, on the outer peripheral surface of the can roll 56, of the gas introduction channel 14 communicating with the gas supply channel 23. Also, the fixed ring unit 22 includes a gas distribution channel 27 formed by an annular recessed groove 27a, including a fixed closed portion and a fixed opening portion, and communicating with a supply pipe 26 outside the vacuum chamber 50, the annular recessed groove 27a being provided in the cylindrical inner peripheral surface of the fixed ring unit 22 so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. The fixed opening portion opens within an angular range in the region on the gas control sliding contact surface of the fixed ring unit 22 which the revolving opening portions 23a of the cylindrical protruding part 21b of the rotary ring unit 21 face, the angular range being a range within which the film (long substrate) 52 is wrapped. Note that reference sign 43 in FIGS. 6 to 8 denotes a packing attachment member.

Further, as illustrated in FIG. 6, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber 50 is not supplied to the gas supply channels 23. Hence, the gas is not discharged from the gas discharge holes 15 in the outer peripheral surface of the can roll 56. Also, as illustrated in FIG. 6, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

In JP 2017 137543 A, the present inventor has proposed a can roll as specified in the preamble of claims 1 and 2, and a long substrate treatment apparatus as specified in the preamble of claim 7. The can roll of JP 2017 137543 A has an outer peripheral surface with an inverted crown shape.

In EP 3 699 319 A1, which is considered as comprised in the state of the art under Article 54(3) EPC, the present inventor has proposed a further development of the can roll of JP 2012 132081 A.

### SUMMARY OF THE INVENTION

### PROBLEM TO BE SOLVED BY THE INVENTION

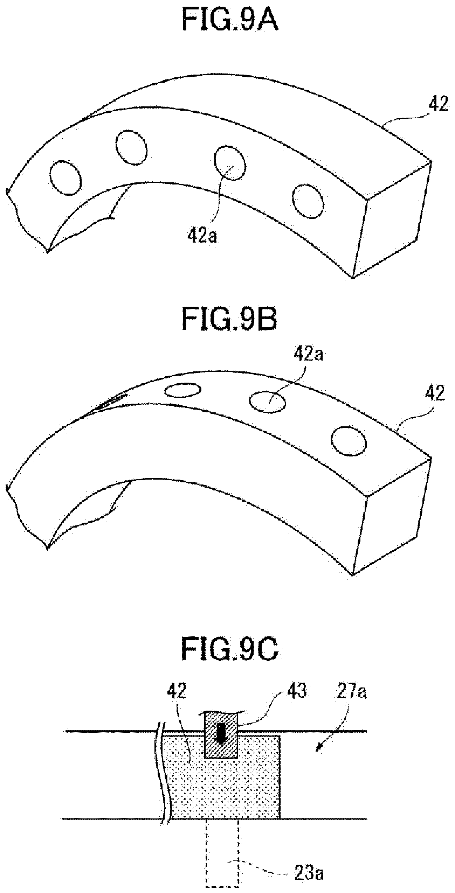

Meanwhile, in the can roll of JP 2012 132081 A including any one of the above rotary joints, the arched packing member 42 to be fitted in the annular recessed groove 27a of the fixed ring unit 22 is made of a fluorine-based resin such as polytetrafluoroethylene. Moreover, as illustrated in FIGS. 9(A) and 9(B), the arched packing member 42 has such an arched shape as to be fitted in the annular recessed groove 27a, and also a plurality of fitting holes 42a in which to fit distal end portions of fixing members (such as fixing screws or piston shafts) of the packing attachment members 43 are provided in one surface of the arched packing member 42.

Note that FIG. 9(A) illustrates the arched packing member employed in the "perpendicular rotary joint" in which the gas control sliding contact surfaces of its rotary ring unit and fixed ring unit are formed perpendicularly to the center axis of the can roll, and FIG. 9(B) illustrates the arched packing member employed in the "parallel rotary joint" in which the gas control sliding contact surfaces of its rotary ring unit and fixed ring unit are formed in parallel to the center axis of the can roll.

Further, as illustrated in FIG. 9(C), the arched packing member 42 is attached in a state of being biased toward the gas control sliding contact surface of the rotary ring unit by using the fixing members (such as fixing screws or piston shafts) of the packing attachment members 43 in order to reliably close the plurality of revolving opening portions 23a, which are provided at the gas control sliding contact surface of the rotary ring unit.

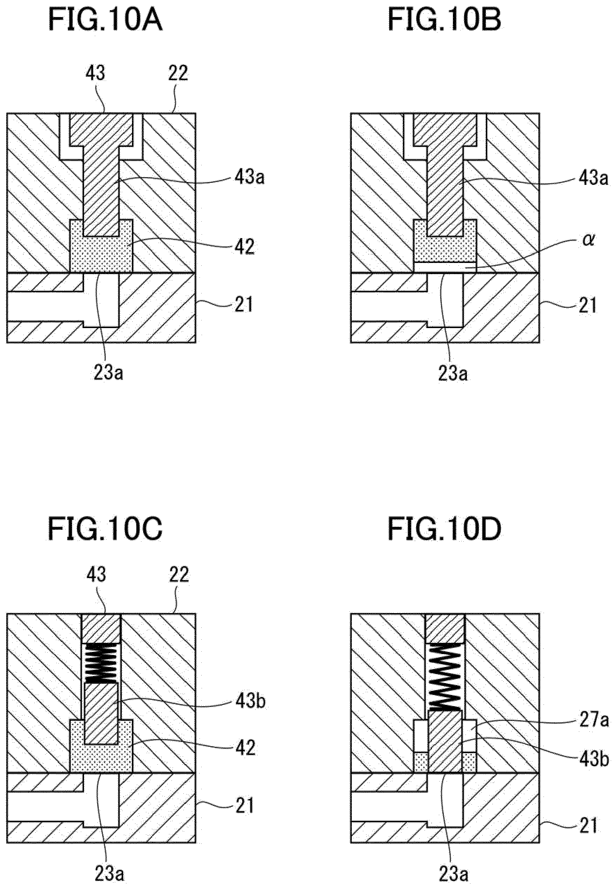

Here, in a case where fixing screws 43a are employed as the fixing members, the distal end of the arched packing member 42 can reliably close the revolving opening portions 23a of the rotary ring unit 21, as illustrated in FIG. 10(A), when the arched packing member 42 is new. However, if the arched packing member 42 wears due to the contact with the gas control sliding contact surface of the rotary ring unit 21, a clearance space α is formed between the distal end of the arched packing member 42 and the gas control sliding contact surface of the rotary ring unit 21, as illustrated in FIG. 10(B). This may cause gas leakage from the revolving opening portions 23a. Then, if the gas leaks from the revolving opening portions 23a at the gas control sliding contact surface, it will be difficult to control the pressure in the gaps between the surface of the can roll and the film. Consequently, the cooling efficiency may become lower or uneven, which may result in formation of wrinkles on the film during the surface treatment.

On the other hand, in a case where piston shafts 43b including biasing means such as a spring member are employed as the fixing members, the arched packing member 42 is constantly in a state of being pressed toward the gas control sliding contact surface of the rotary ring unit 21. Thus, even if the arched packing member 42 wears due to the contact with the gas control sliding contact surface, it is possible to close the revolving opening portions 23a of the rotary ring unit 21, as illustrated in FIGS. 10(C) and 10(D).

However, if the wear of the arched packing member 42 further progresses and the distal end of the piston shaft 43b projects outward (i.e., toward the gas control sliding contact surface of the rotary ring unit 21) beyond the opening plane of the annular recessed groove 27a as illustrated in FIG. 10(D), the distal end of the piston shaft 43b damages the revolving opening portions 23a of the rotary ring unit 21. This leads to a fatal problem in that the rotary ring unit 21 can no longer be used after this.

The present invention has been made in view of such a problem and an object thereof is to provide a can roll and a long substrate treatment apparatus capable of reliably closing revolving opening portions of a rotary ring unit even when an arched packing member wears due to contact with a gas control sliding contact surface of the rotary ring unit and preventing damage of the revolving opening portions by fixing members (piston shafts including biasing means) of packing attachment members, and also to provide a method of managing the long substrate treatment apparatus capable of managing the timing for replacement of the arched packing member.

### MEANS FOR SOLVING THE PROBLEM

To solve the above problem, the present inventor has conducted earnest studies on the configuration of the piston shaft in each packing attachment member. As a result, the present inventor has completed the present invention, which is capable of preventing damage of the revolving opening portions by the piston shaft.

That is, a first aspect according to the present invention is a can roll as specified in claim 1.

A second aspect according to the present invention is a can roll as specified in claim 2.

Further developments of the can roll are specified in claims 3 to 6.

A third aspect according to the present invention is a long substrate treatment apparatus as specified in claim 7.

Further developments of the long substrate treatment apparatus are specified in claims 8 to 12.

A fourth aspect according to the present invention is a method of managing the long substrate treatment apparatus as specified in claim 13.

### EFFECTS OF THE INVENTION

In the can roll and the long substrate treatment apparatus according to the present invention, the arched packing member, which is fitted in the predetermined region inside the annular recessed groove, is attached so as to be biased toward the gas control sliding contact surface of the rotary ring unit by the piston member of the packing attachment member, which is disposed on the back side of the arched packing member. Thus, even if the arched packing member wears due to the contact with the gas control sliding contact surface, it is possible to reliably close the revolving opening portions of the rotary ring unit.

Also, the range of stroke of the piston shaft of the piston member, which fixes the arched packing member, is restricted such that the distal end of the piston shaft remains behind the opening plane of the annular recessed groove. Thus, even if the state of wear of the arched packing member progresses due to the contact with the gas control sliding contact surface, the distal end of the piston shaft does not project to the gas control sliding contact surface of the rotary ring unit. It is therefore possible to also prevent damage of the revolving opening portions of the rotary ring unit.

Further, in the method of managing the long substrate treatment apparatus according to the present invention, gas leakage from the revolving opening portions is checked based on a decrease in gas pressure inside the gas introduction channels or an increase in introduced gas amount for maintaining a specified pressure inside the gas introduction channels. This enables detection of the state of wear of the arched packing member. It is therefore possible to manage the timing for replacement of the arched packing member.

### BRIEF DESCRIPTION OF THE DRAWINGS

FIG. 1 is an explanatory diagram illustrating an example of a roll-to-roll type long substrate treatment apparatus in which a can roll according to the present invention is preferably used.
FIG. 2 is a schematic perspective view of a can roll according to JP 2012 132081 A including a rotary joint.
FIG. 3 is a schematic perspective view of a fixed ring unit and a rotary ring unit each including a gas control sliding contact surface formed perpendicularly to the center axis of a can roll.
FIG. 4 is an explanatory diagram illustrating a schematic configuration of the can roll in which the gas control sliding contact surfaces of the fixed ring unit and the rotary ring unit are formed perpendicularly to the center axis of the can roll.
FIG. 5 is a side view and A-A' and B-B' cross-sectional views of a rotary joint including the fixed ring unit and the rotary ring unit each including a gas control sliding contact surface formed perpendicularly to the center axis of the can roll.
FIG. 6 is a schematic perspective view of a fixed ring unit and a rotary ring unit each including a gas control sliding contact surface formed in parallel to the center axis of a can roll.
FIG. 7 is an explanatory diagram illustrating a schematic configuration of the can roll in which the gas control sliding contact surfaces of the fixed ring unit and the rotary ring unit are formed in parallel to the center axis of the can roll.
FIG. 8 is a side view and A-A' and B-B' cross-sectional views of a rotary joint including the fixed ring unit and the rotary ring unit each including a gas control sliding contact surface formed in parallel to the center axis of the can roll.
FIG. 9(A) is a schematic partial perspective view of an arched packing member employed in a "perpendicular rotary joint", FIG. 9(B) is a schematic partial perspective view of an arched packing member employed in a "parallel rotary joint", and FIG. 9(C) is an explanatory diagram illustrating a state where one of the arched packing members is attached in a state of being biased toward a gas control sliding contact surface.
FIG. 10(A) is an explanatory diagram illustrating a state where a fixing screw is employed as a fixing member of a packing attachment member, FIG. 10(B) is an explanatory diagram illustrating a problem with employing the fixing screw (gas leakage from revolving opening portions), FIG. 10(C) is an explanatory diagram illustrating a state where a piston shaft including biasing means is employed as the fixing member of a packing attachment member, and FIG. 10(D) is an explanatory diagram illustrating a problem with employing the piston shaft (damage of the revolving opening portions).
FIGS. 11(A) and 11(B) are schematic perspective views illustrating a state where a piston member of the present invention whose range of stroke is restricted is employed as the fixing member of a packing attachment member.
FIGS. 12(A) to 12(C) are explanatory diagrams of the operation of the piston member of the present invention.

### MODES FOR PRACTICING THE INVENTION

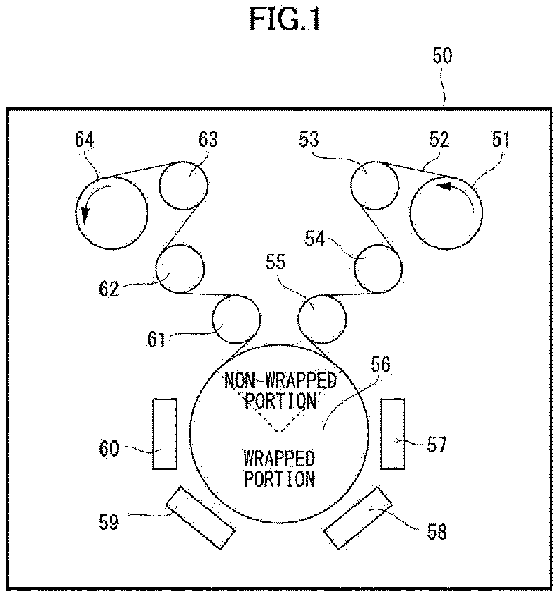

Specific examples of can rolls according to the present invention and a conventional example and long substrate treatment apparatuses equipped with them are specifically described below with reference to the drawings. First, a long substrate vacuum deposition apparatus as an example of a long substrate treatment apparatus is described with reference to FIG. 1. Note that the description is given of a case where a long heat-resistant resin film is used as an example of the long substrate. Also, the description is given by taking a sputtering process as an example of the treatment that applies a thermal load which is to be performed on the long substrate.

### (1) Long Substrate Treatment Apparatus

The long heat-resistant resin film deposition apparatus illustrated in FIG. 1 is an apparatus called a sputtering web coater, and is preferably used to perform a deposition process continuously and efficiently on a surface of a long heat-resistant resin film transferred in a roll-to-roll manner.

Specifically, the deposition apparatus for a long heat-resistant resin film transferred in a roll-to-roll manner (sputtering web coater) is provided in a vacuum chamber 50, and performs a predetermined deposition process on a long heat-resistant resin film 52 unwound from a unwinding roll 51 and then winds up the long heat-resistant resin film 52 with a winding roll 64. A can roll 56 that is rotationally driven by a motor is disposed at a position along the transfer path from the unwinding roll 51 to the winding roll 64. Inside this can roll 56 is circulated a coolant whose temperature is adjusted outside the vacuum chamber 50. Here, the portion of the outer peripheral surface of the can roll 56 on which the film 52 is wrapped is referred to as "wrapped portion" while the portion on which the film 52 is not wrapped is referred to as "non-wrapped portion".

In the vacuum chamber 50, for sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. The shape and material of the vacuum chamber 50 are not particularly limited but various shapes and materials are usable as long as they can withstand the above depressurized state. The vacuum chamber 50 is equipped with various apparatuses not illustrated such as dry pumps, turbomolecular pumps, and cryocoils to depressurize the inside of the vacuum chamber 50 as mentioned above and maintain that state.

A free roller 53 that guides the long heat-resistant resin film 52 and a tension sensor roll 54 that measures the tension of the long heat-resistant resin film 52 are disposed in this order along the transfer path from the unwinding roll 51 to the can roll 56. Also, the long heat-resistant resin film 52 transferred from the tension sensor roll 54 toward the can roll 56 undergoes an adjustment relative to the circumferential speed of the can roll 56 by a motor-driven feed roller 55 provided near the can roll 56. This enables the long heat-resistant resin film 52 to be in tight contact with the outer peripheral surface of the can roll 56.

A motor-driven feed roller 61 that performs an adjustment relative to the circumferential speed of the can roll 56, a tension sensor roll 62 that measures the tension of the long heat-resistant resin film 52, and a free roller 63 that guides the long heat-resistant resin film 52 are disposed in this order along the transfer path from the can roll 56 to the winding roll 64, like the above case.

At the unwinding roll 51 and the winding roll 64, the tension of the long heat-resistant resin film 52 is balanced via torque control with powder clutches or the like. The long heat-resistant resin film 52 is unwound from the unwinding roll 51 and wound up around the winding roll 64 by rotation of the can roll 56 and the motor-driven feed rollers 55 and 61, which rotate according to the can roll 56.

Magnetron sputtering cathodes 57, 58, 59 and 60 as deposition means are positioned near the can roll 56 so as to face the transfer path defined on the outer peripheral surface of the can roll 56 (i.e., the region on the outer peripheral surface of the can roll 56 on which to wrap the long heat-resistant resin film 52). Note that the above-mentioned angular range is referred to the holding angle of the long heat-resistant resin film 52, and this range is referred to as the wrapped portion.

For sputtering deposition of a metal film, plate-shaped targets can be used, as illustrated in FIG. 1. However, in the case of using plate-shaped targets, generation of nodules (growth of foreign matter) may occur on the targets in some cases. If this is problematic, it is preferable to use cylindrical rotary targets, which are free from the generation of nodules and also have high target use efficiency.

Also, since the deposition apparatus for the long heat-resistant resin film 52 in FIG. 1 is assumed to perform a sputtering process as the treatment that applies a thermal load, magnetron sputtering cathodes are illustrated. However, in a case where the treatment that applies a thermal load is a different treatment such that CVD (chemical vapor deposition) or a vapor deposition process, different vacuum deposition means is provided in place of the plate-shaped targets.

### (2) Can Roll with Gas Discharge Mechanism

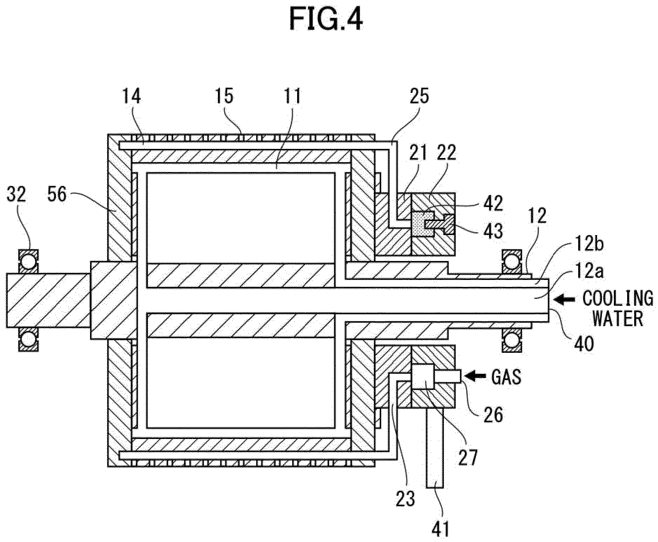

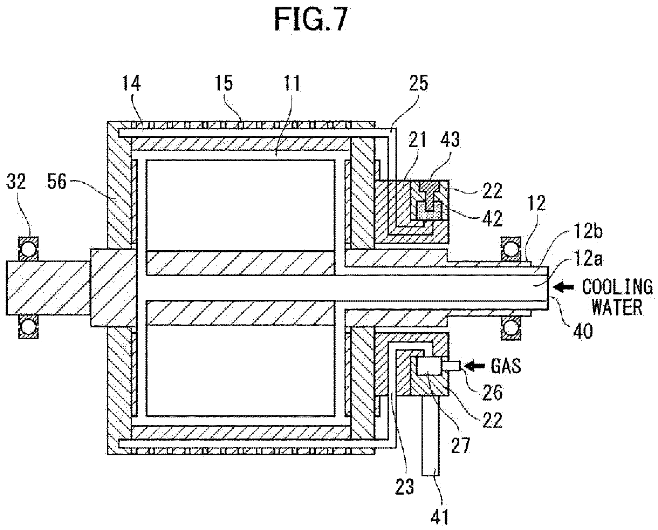

Next, a can roll with a gas discharge mechanism is described with reference to FIGS. 2, 4, and 7. A can roll 56 with a gas discharge mechanism includes a cylindrical member 10 that is rotationally driven about a rotation center axis 56a by a drive apparatus not illustrated (see FIG. 2). On the outer surface of this cylindrical member 10, a transfer path is defined along which to wrap and transfer a long heat-resistant resin film 52. On the inner surface side of the cylindrical member 10, a coolant circulation portion 11 (see FIGS. 4 and 7) with a jacket structure is formed through which a coolant such as cooling water flows.

Also, a rotary shaft 12 (see FIG. 2) situated at the position of the rotation center axis 56a of the cylindrical member 10 has a double-pipe structure, and the coolant circulates between a coolant cooling apparatus not illustrated which is provided outside the vacuum chamber 50 and the coolant circulation portion 11 through this rotary shaft 12. This makes it possible to adjust the temperature of the outer peripheral surface of the can roll 56.

Specifically, the coolant, such as cooling water, cooled by the coolant cooling apparatus is introduced from a cooling water inlet 40 and sent through an inner pipe 12a to the coolant circulation portion 11, at which the coolant receives the heat of the long heat-resistant resin film 52, thereby rising in temperature. Thereafter, the coolant is returned again to the coolant cooling apparatus through a space between the inner pipe 12a and an outer pipe 12b. Note that bearings 32 that support the rotating can roll 56 are provided on the outer side of the outer pipe 12b.

A plurality of gas introduction channels 14 are arranged over the entire circumference of the cylindrical member 10 of this can roll 56 at substantially equal intervals in the circumferential direction. The plurality of gas introduction channels 14 are each bored in a thick portion of the cylindrical member 10 so as to extend along the direction of the rotation center axis 56a of the can roll 56. Note that FIG. 2 illustrates an example where 12 gas introduction channels 14 are arranged over the entire circumference at equal intervals.

Each gas introduction channel 14 includes a plurality of gas discharge holes 15 opening toward the outer surface of the cylindrical member 10 (i.e. the outer peripheral surface of the can roll 56). The plurality of gas discharge holes 15 are bored at substantially equal intervals along the direction of the rotation center axis 56a of the can roll 56. Moreover, as illustrated in FIG. 2, a gas is supplied from outside the vacuum chamber 50 into each gas introduction channel 14 through a rotary joint 20 including a rotary ring unit 21 and a fixed ring unit 22. In this way, the gas can be introduced into the gap regions (clearances) formed between the outer peripheral surface of the can roll 56 and the long heat-resistant resin film 52 wrapped thereon.

As mentioned above, the long heat-resistant resin film 52 and the surface of the can roll 56 are not completely flat surfaces. Then, with a vacuum therein, the gap regions (clearances) are thermally insulated by the vacuum and accordingly lower the heat transfer efficiency. This causes the formation of wrinkles on the heat-resistant resin film 52 by the heat during the sputtering deposition.

Meanwhile, according to "Improvement of Web Condition by the Deposition Drum Design", 2000 Society of Vacuum Coaters, 50th Annual Technical Conference Proceeding (2007), p.749, in a case where the introduced gas is an argon gas, then when the pressure of the introduced gas is 500 Pa and the distance across a gap is approximately 40 um or shorter, the thermal conductivity in the gap is 250 (W/m²·K). For the can roll with a gas discharge mechanism of the present invention too, the higher the gas pressure in the gaps between the surface of the can roll and the film at the wrapped portion, the higher the thermal conductivity and the higher the film cooling efficiency. However, if the gas pressure is higher than a reaction P = T/R (R: the radius of the can roll) which is a force with which the film is pressed against the can roll under its tension T, the film floats from the can roll, which makes it difficult to control the gas pressure. It is therefore important to control the gas pressure in the gaps between the surface of the can roll and the film. Moreover, accurate pressure control cannot be performed in some cases if the packing member in the rotary joint fails to completely stop the introduction of the gas to the non-wrapped portion.

Description is given below of a "perpendicular rotary joint" in which gas control sliding contact surfaces of its rotary ring unit and fixed ring unit are formed perpendicularly to the center axis of a can roll, and the "parallel rotary joint" in which gas control sliding contact surfaces of its rotary ring unit and fixed ring unit are formed in parallel to the center axis of a can roll.

### (3) Rotary Joint

### (3-1) Perpendicular Rotary Joint

As illustrated in FIGS. 3 to 5, the perpendicular rotary joint includes a rotary ring unit 21 and a fixed ring unit 22 fixed by a fixing member 41 so as not to rotate.

Further, the rotary ring unit 21 includes a plurality of gas supply channels 23 that communicate with the plurality of gas introduction channels 14 through connection pipes 25, respectively. Moreover, each gas supply channel 23 includes a revolving opening portion 23a at the gas control sliding contact surface, the revolving opening portion 23a opening at an angular position corresponding to the angular position, on the outer peripheral surface of the can roll 56, of the gas introduction channel 14 communicating with the gas supply channel 23 through the corresponding connection pipe 25 (substantially the same angular position as the angular position on the outer peripheral surface of the can roll 56).

On the other hand, the fixed ring unit 22 includes a gas distribution channel 27 formed by an annular recessed groove 27a, including a fixed closed portion and a fixed opening portion, and communicating with a supply pipe 26 outside the vacuum chamber, the annular recessed groove 27a being provided in the gas control sliding contact surface so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. Also, the fixed opening portion opens within an angular range in the region on the gas control sliding contact surface of the fixed ring unit 22 which the revolving opening portions 23a of the rotary ring unit 21 face, the angular range being a range within which the long heat-resistant resin film 52 is wrapped.

Further, as illustrated in FIG. 3, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber 50 is not supplied to the gas supply channels 23. Hence, the gas is not discharged from the gas discharge holes 15 in the outer peripheral surface of the can roll 56.

On the other hand, as illustrated in FIG. 3, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

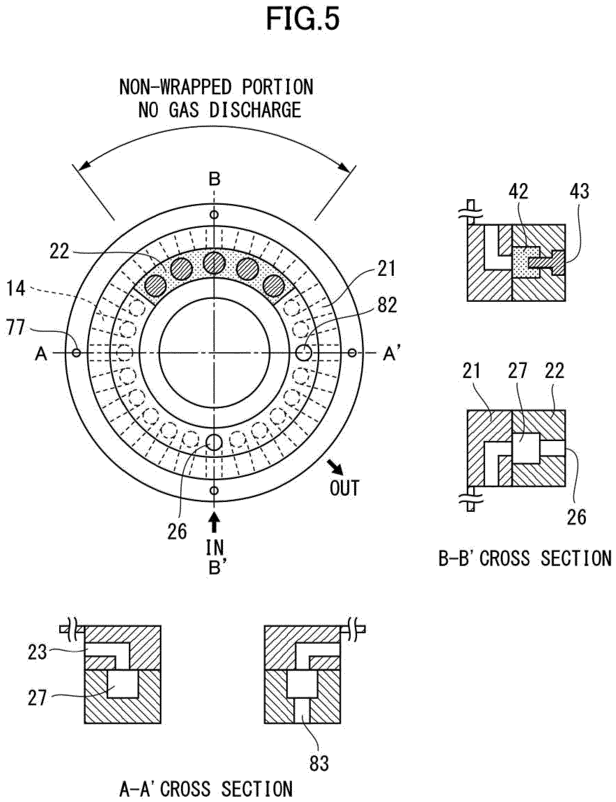

Meanwhile, reference sign 43 in FIGS. 3 to 5 denote a packing attachment member, and reference sign 77 in FIG. 5 denotes a fixing screw hole in the rotary ring unit 21. Also, reference signs 82 and 83 in FIG. 5 denote a pressure gauge port for measuring the pressure in the gas distribution channel 27, which is equal to the gas pressure in the gaps between the outer peripheral surface of the can roll 56 and the film 52 at the wrapped portion region of the surface of the can roll 56, at which the film 52 is wrapped.

### (3-2) Parallel Rotary Joint

As illustrated in FIGS. 6 to 8, the parallel rotary joint includes a rotary ring unit 21 which has a T-shaped cross section and includes a cylindrical base part 21a and a cylindrical protruding part 21b, and a fixed ring unit 22 in which the cylindrical protruding part 21b of the rotary ring unit 21 is fitted and which is fixed by a fixing member 41 so as not to rotate.

Further, the rotary ring unit 21 includes a plurality of gas supply channels 23 that communicate with the plurality of gas introduction channels 14 through connection pipes 25, respectively. Moreover, each gas supply channel 23 includes a revolving opening portion 23a at the gas control sliding contact surface of the cylindrical protruding part 21b, the revolving opening portion 23a opening at an angular position corresponding to the angular position, on the outer peripheral surface of the can roll 56, of the gas introduction channel 14 communicating with the gas supply channel 23.

On the other hand, the fixed ring unit 22 includes a gas distribution channel 27 formed by an annular recessed groove 27a, including a fixed closed portion and a fixed opening portion, and communicating with a supply pipe 26 outside the vacuum chamber 50, the annular recessed groove 27a being provided in the cylindrical inner peripheral surface of the fixed ring unit 22 so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. Also, the fixed opening portion opens within an angular range in the region on the gas control sliding contact surface of the fixed ring unit 22 which the revolving opening portions 23a of the cylindrical protruding part 21b of the rotary ring unit 21 face, the angular range being a range within which the long heat-resistant resin film 52 is wrapped.

Further, as illustrated in FIG. 6, at the non-wrapped portion region of the outer peripheral surface of the can roll 56, at which the film 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber 50 is not supplied to the gas supply channels 23. Hence, the gas is not discharged from the gas discharge holes 15 in the outer peripheral surface of the can roll 56.

On the other hand, as illustrated in FIG. 6, at the wrapped portion region of the outer peripheral surface of the can roll 56, at which the film 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

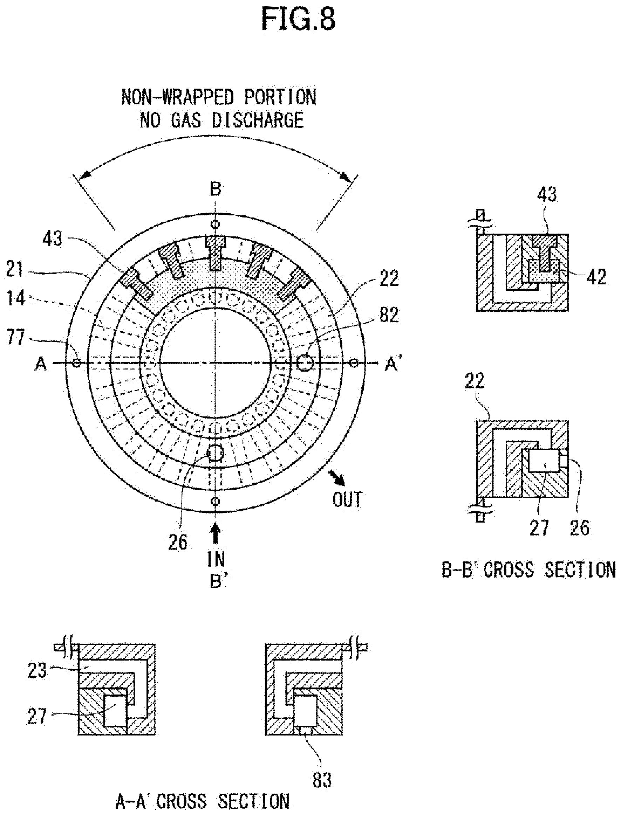

Meanwhile, reference sign 43 in FIGS. 6 to 8 denote a packing attachment member, and reference sign 77 in FIG. 8 denotes a fixing screw hole in the rotary ring unit 21. Also, reference signs 82 and 83 in FIG. 8 denote a pressure gauge port for measuring the pressure in the gas distribution channel 27, which is equal to the gas pressure in the gaps between the outer peripheral surface of the can roll 56 and the film 52 at the wrapped portion region of the surface of the can roll 56, at which the film 52 is wrapped.

### (4) Fixing Member of Packing Attachment Member

### (4-1) Fixing Screw

In a case where fixing screws are employed as the fixing members for the arched packing member, the distal end of the arched packing member 42 can reliably close the revolving opening portions 23a of the rotary ring unit 21, as illustrated in FIG. 10(A), when the arched packing member 42 is new. However, if the arched packing member 42 wears due to the contact with the gas control sliding contact surface of the rotary ring unit 21, a clearance space α is formed between the distal end of the arched packing member 42 and the gas control sliding contact surface of the rotary ring unit 21, as illustrated in FIG. 10(B). This leads to a problem in that the gas leaks from the revolving opening portions 23a, as mentioned above.

### (4-2) Piston Shaft Including Biasing Means

In a case where piston shafts 43b including biasing means are employed as the fixing members, the arched packing member 42 is constantly in a state of being pressed toward the gas control sliding contact surface of the rotary ring unit 21. Thus, even if the arched packing member 42 wears due to the contact with the gas control sliding contact surface, it is possible to close the revolving opening portions 23a of the rotary ring unit 21, as illustrated in FIGS. 10(C) and 10(D). However, if the state of wear of the arched packing member 42 further progresses and the distal end of the piston shaft 43b projects outward (toward the gas control sliding contact surface of the rotary ring unit 21) beyond the opening plane of the annular recessed groove 27a as illustrated in FIG. 10(D), the distal end of the piston shaft 43b contacts and damages the revolving opening portions 23a of the rotary ring unit 21. This leads to a fatal problem in that the rotary ring unit 21 can no longer be used after this, as mentioned above.

### (4-3) Packing Attachment Member According to the Present Invention

A piston member (fixing member) of each packing attachment member according to the present invention is characterized in that the range of stroke of the piston shaft in the piston member is restricted such that the distal end of the piston shaft remains behind the opening plane of the annular recessed groove.

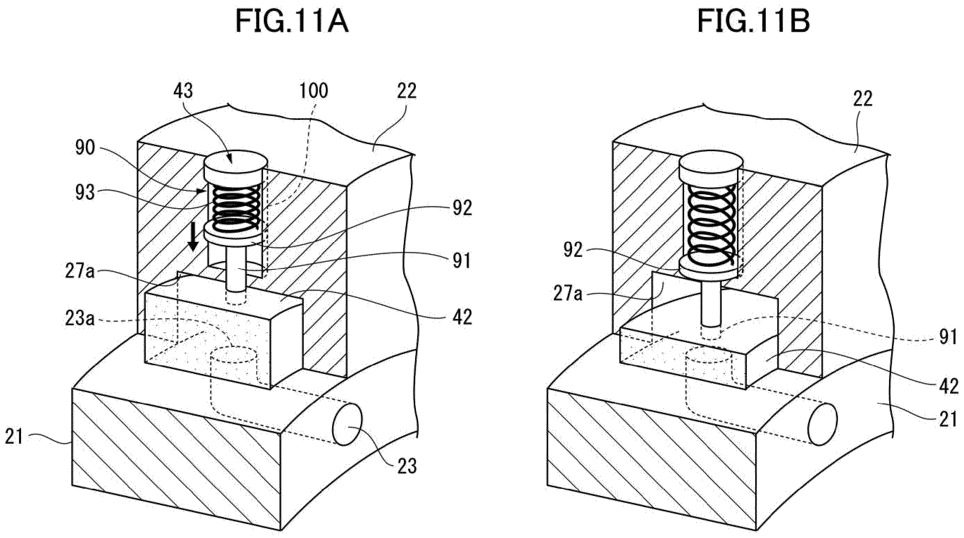

A specific example of the packing attachment member according to the present invention is discussed below with reference to FIGS. 11(A) and 11(B). Specifically, the packing attachment member 43 according to the present invention includes: a tubular main body 90 housed in an attachment member housing portion 100 provided behind the annular recessed groove 27a, in which the arched packing member 42 is fitted, closed on one end side, and including a piston shaft insertion hole portion on another end side; a piston member housed in the tubular main body 90 and including a piston shaft 91 penetrating through the hole portion, and a flange portion 92 provided on the proximal end side of the piston shaft 91; and biasing means (coil spring) 93 housed in the tubular main body 90 and biasing the piston shaft 91 toward the annular recessed groove 27a via the flange portion 92 of the piston member.

Further, the distal end of the piston shaft 91 of the piston member is inserted into the arched packing member 42 from the back side of the arched packing member 42 through a hole portion provided in the bottom surface of the annular recessed groove 27a. Then, as the arched packing member 42 wears due to the contact with the gas control sliding contact surface of the rotary ring unit 21, the flange portion 92 of the piston member gets locked to the hole portion of the tubular main body 90 to thereby restrict the range of stroke of the piston shaft 91. Thus, the distal end of the piston shaft 91 remains behind the opening plane of the annular recessed groove 27a (the distal end of the piston shaft 91 does not project to the gas control sliding contact surface of the rotary ring unit 21), as illustrated in FIG. 11(B).

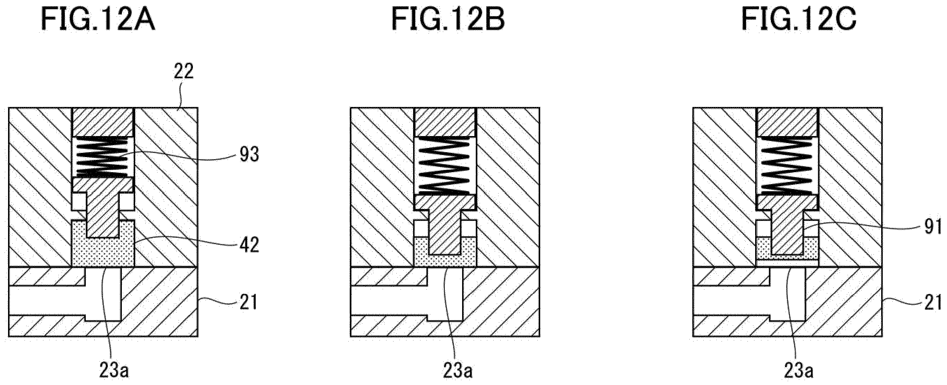

Moreover, the biasing means (coil spring) 93 operates such that the arched packing member 42 is constantly in a state of being pressed toward the gas control sliding contact surface of the rotary ring unit 21. Thus, even if the arched packing member 42 wears due to the contact with the gas control sliding contact surface, it is possible to close the revolving opening portions 23a of the rotary ring unit 21, as illustrated in FIGS. 12(A) and 12(B). Also, even if the state of wear of the arched packing member 42 progresses due to the contact with the gas control sliding contact surface of the rotary ring unit 21, the range of stroke of the piston shaft 91 is restricted, so that the distal end of the piston shaft 91 does not project to the gas control sliding contact surface of the rotary ring unit 21, as illustrated in FIG. 12(C). It is therefore possible to prevent damage of the revolving opening portions 23a of the rotary ring unit 21.

Also, if the wear of the arched packing member 42 progresses such that the gas leaks from the revolving opening portions 23a, the pressure drops when the pressure gauge attached to the fixed ring unit 22 is under flow rate control, and the gas flow rate for maintaining a preset pressure increases when the pressure gauge is under pressure control. This makes it possible to know the life of the arched packing member 42 (i.e., timing for replacement of the packing member).

Further, in a case where the introduced gas is the same as the gas in the sputtering atmosphere, the sputtering atmosphere will not be contaminated by the introduced gas. Note that the rotary joint may be attached not only on one side of the can roll but on both sides of the can roll, and is preferably attached on both sides of the can roll to stabilize the gas pressure.

### (5) Long Substrate and Surface Treatment That Applies Thermal Load

The long substrate treatment apparatus according to the present invention has been described by taking a heat-resistant resin film as an example of the long substrate. However, other resin films, as a matter of course, and also metal films such as metal foils and metal strips are also usable as the long substrate used in the long substrate treatment apparatus according to the present invention. Examples of the resin films may include resin films with relatively poor heat resistance such as a polyethylene terephthalate (PET) film and heat-resistant resin films such as a polyimide film.

In the case of fabricating the metal film-coated heat-resistant resin film mentioned above, a heat-resistant resin film selected from among a polyimidebased film, a polyamide-based film, a polyester-based film, a polytetrafluoroethylene-based film, a polyphenylene sulfide-based film, a polyethylene naphthalate-based film, and a liquid-crystal polymerbased film is preferably used. This is because a metal film-coated heat-resistant resin film obtained using any of these is superior in flexibility required for metal film-coated flexible substrates, strength necessary to practical use, and electrical insulation performance preferable as a wiring material.

Also, a metal film-coated heat-resistant resin film can be manufactured by applying the above heat-resistant resin film as the long substrate to the above long substrate vacuum deposition apparatus and performing sputtering deposition of metal films on the surface of the heat-resistant resin film. For example, by processing the heat-resistant resin film by a metallizing method using the above deposition apparatus (sputtering web coater), a long metal film-coated heat-resistant resin film can be obtained which is the heat-resistant resin film with a film made of an Ni-based alloy or the like and a Cu film laminated on the surface of the heat-resistant resin film.

After the deposition process, the above metal film-coated heat-resistant resin film is sent to a further process, in which the metal film-coated heat-resistant resin film is processed by a subtractive method into a flexible wiring substrate including a predetermined wiring pattern. Here, the subtractive method refers to a method of manufacturing a flexible wiring substrate by removing a metal film not covered by a resist (e.g. the above Cu film) by etching.

The above film made of an Ni-based alloy or the like is called a seed layer, and its composition is selected as appropriate based on properties required for the metal film-coated heat-resistant resin film such as electric insulation performance and migration resistance. Generally, however, it is made of a publicly known alloy such as an Ni-Cr alloy, Inconel, constantan, or Monel. Note that a wet plating method is sometimes used in a case where a metal film (Cu film) of the metal film-coated long heat-resistant resin film is desired to be thicker. In this case, used is a method in which the metal film is formed by only an electroplating process or a method in which a combination of wet plating processes such as an electroless plating process as primary plating and an electrolytic plating process as secondary plating. For the above wet plating processes, general wet plating conditions can be employed.

Note that the description has been given by taking, as an example, a metal film-coated heat-resistant resin film obtained by laminating films of metals such as an Ni-Cr alloy and Cu on a long heat-resistant resin film. However, it is also possible to use the present invention to form films other than the above metal films such as oxide films, nitride films, and carbide films in accordance with the purpose.

Also, the long substrate treatment apparatus according to the present invention has been described by taking a long substrate vacuum deposition apparatus as an example. However, the above long substrate treatment apparatus also covers treatments that apply a thermal load such as plasma treatment and ion beam treatment, besides vacuum deposition such as sputtering performed on a long substrate inside a vacuum chamber under a depressurized atmosphere. While these plasma treatment and ion beam treatment modify the surface of a long substrate, these apply a thermal load to the long substrate. The the can roll according to the present invention and the long substrate treatment apparatus using this can roll is applicable to these cases and can prevent formation of wrinkles on the long substrate due to the thermal load without leaking a large amount of the introduced gas. Examples of the plasma treatment include a method in which a long substrate is processed with an oxygen plasma or nitrogen plasma generated via discharge through a mixed gas of argon and oxygen or a mixed gas of argon and nitrogen under a depressurized atmosphere. Also, the ion beam treatment refers to a treatment in which a plasma discharge is generated in a magnetic field gap where a strong magnetic field is applied, and positive ions in the plasma as an ion beam to a long substrate. Note that a publicly known ion beam source can be used in the ion beam treatment. Also, these plasma treatment and ion beam treatment are both performed under a depressurized atmosphere.

### EXAMPLES

Examples of the present invention are specifically described below.

### [Design of Rotary Joint]

The diameter of the rotary joint (rotary ring unit and fixed ring unit) was set at approximately 400 mm, and the number of connection pipes 25 on the rotary ring unit, connected to (communicating with) the gas introduction channels 14 of the can roll, was set at 36. Thus, gas control at angular intervals of 10° (360°/36 = 10°) was possible.

Also, the feed roller 55, provided on the infeed side of the can roll, was set such that the can roll and the film contacted each other at a 20° angle position, and the feed roller 61, provided on the outfeed side of the can roll, was set such that the can roll and the film contacted each other at a 340° angle position (in other words, the angle across the non-wrapped portion was set at 40°).

Note that 20° was set as the angles on both sides of the angular range of the non-wrapped portion on which gas control could be unstable, and the gas stop angle for the non-wrapped portion (the angle of the fixed closed portion formed by the arched packing member 42 fitted in a predetermined region inside the annular recessed groove 27a forming the gas distribution channel 27 of the fixed ring unit 22) was set at 90° (> 40° (the non-wrapped portion) + 20° × 2 (the unstable portions on both sides)).

Note that two types of rotary joints were fabricated which were the "perpendicular rotary joint" illustrated in FIGS. 3 to 5 and the "parallel rotary joint" illustrated in FIGS. 6 to 8.

### [Arched Packing Members and Fixing Members of Packing Attachment Members]

In view of slipperiness and durability, a fluorine-based resin (Teflon (registered trademark)) was used as the material of the packing members, and two types of arched packing members were fabricated which were the arched packing member illustrated in FIG. 9(A) (thickness: 10mm) for the "perpendicular rotary joint" and the arched packing member illustrated in FIG. 9(B) (thickness: 10mm) for the "parallel rotary joint".

Also, as the fixing members of the packing attachment members, the fixing screw 43a illustrated in FIG. 10(A), the piston shaft 43b illustrated in FIG. 10(C), and the piston shaft 91 of the present invention illustrated in FIG. 11(A) were prepared. Note that the amount of insertion of each fixing member (fixing screw 43a, piston shaft 43b, piston shaft 91) into the arched packing member was 5mm, and only the piston shaft 91 of the present invention was processed such that its stroke would stop at 4 mm and the piston shaft 91 would not move forward from a distance of 1 mm to the packing.

### [Example]

Long metal film-coated heat-resistant resin films were fabricated using the deposition apparatus (sputtering web coater) illustrated in FIG. 1. As the long heat-resistant resin film (hereinafter, referred to as the film 52), a heat-resistant polyimide film "UPILEX (registered trademark)", manufactured by Ube Industries, Ltd, measuring 500 mm in width, 800 m in length, and 25 um in thickness was used.

As the can roll 56, a can roll with a gas introduction mechanism having a jacket roll structure as illustrated in FIG. 2 was used. As the cylindrical member 10 of this can roll 56, a stainless cylindrical member measuring 900 mm in diameter and 750 mm in width was used, and hard chromium plating was performed on its outer peripheral surface. 180 gas introduction channels 14 were bored over the entire circumference of a thick portion of this cylindrical member 10 at equal intervals in the circumferential direction, the gas introduction channels 14 measuring 5 mm in inner diameter and extending in parallel to the direction of the rotation axis of the can roll 56. Note that, of the two ends of each gas introduction channel 14, the distal end was formed into a closed bottom so as not to penetrate through the cylindrical member 10.

Each gas introduction channel 14 was provided with 47 gas discharge holes 15 measuring 0.2 mm in inner diameter and opening toward the outer surface of the cylindrical member 10 (i.e. the outer peripheral surface of the can roll 56). These 47 gas discharge holes 15 were arranged at 10-mm intervals in a direction perpendicular to the direction of advance of the film 52 within a region between lines situated 20 mm inward from both sides of the transfer path of the film 52 defined on the outer surface of the cylindrical member 10. Specifically, the gas discharge holes 15 were not provided within 145-mm regions from both sides of the outer peripheral surface of the can roll 56.

As described above, 180 gas introduction channels 14 were arranged over the entire circumference of the cylindrical member 10 at equal intervals in the circumferential direction. It is difficult to directly connect these 180 gas introduction channels 14 to the rotary joint 20. For this reason, sets of five gas introduction channels 14 were connected to branched pipes (not illustrated) and then connected to the ends of the connection pipes 25 on the rotary ring unit 21. Specifically, on the rotary ring unit 21 of the rotary joint 20, 36 connection pipes 25 were formed, as mentioned above, through each of which the gas was introduced collectively for 10°.

As for the metal films formed on the film 52, a Cu film was formed on an Ni-Cr film, which was a seed layer. To do so, an Ni-Cr target was used as the magnetron sputter target 57, and Cu targets were used as the magnetron sputter targets 58, 59, and 60. The tension at each of the unwinding roll 51 and the winding roll 64 was 200 N. The can roll 56 was controlled at 20°C by water cooling. Here, a cooling effect cannot be expected be achieved without a good efficiency of heat transfer between the film 52 and the can roll 56.

The film 52 in a rolled up state was set on the unwinding roll 51 side of this deposition apparatus, and one end of the film 52 was attached to the winding roll 64 through the can roll 56. In this state, the air in the vacuum chamber 50 was evacuated to 5 Pa by using a plurality of dry pumps and evacuated further to 3 × 10⁻³ Pa by using a plurality of turbomolecular pumps and cryocoils.

Subsequently, a rotational drive apparatus was actuated to transfer the film 52 at a transfer speed of 3 m/min while an argon gas was introduced at 300 sccm and also electric power control was performed to apply an electric power of 10 kW to the magnetron sputter cathodes 57, 58, 59, and 60. Further, with a diaphragm gauge attached to the pressure gauge port 82, 83 in the rotary joint mounted to the can roll 56, the flow rate of the argon gas from the supply pipe 26 of the fixed ring unit 22 was controlled such that the gas pressure in the gaps between the surface of the can roll and the film could be 800Pa. Note that the gas flow rate in this state was 20 sccm.

A treatment of continuously depositing a seed layer made of an Ni-Cr film and a Cu film to be deposited on the seed layer was started under the above conditions on one surface of the film 52 transferred in a roll-to-roll manner.

While this treatment was performed, the surface of the film 52 on the can roll 56, into which the gas was being introduced, was observed through a window through which the surface of the film 52 on the can roll 56 in the middle of the deposition could be observed. Film wrinkles due to the thermal load were not observed on the film 52 immediately after the deposition that had passed the deposition zone with the magnetron sputtering cathodes 57, 58, 59, and 60.

### [Comparison between Fixing Members]

When the above deposition process was carried out, the functions of the fixing members (the fixing screw 43a, the piston shaft 43b, and the piston shaft 91 of the present invention) were compared.

The result is listed in table 1.

**Table 1**

| Fixing Member of Gas Flow Rate (sccm) for Maintaining Pressure of 800 Pa in Packing Gaps | | | | | |
|---|---|---|---|---|---|
| Attachment Member | Initial Stage | After 200 Hours | After 4000 Hours | After 4200 Hours | After 5000 Hours |
| Fixed Screw | 20 | 22 (Packing Replaced) | ----- | ----- | ----- |
| Conventional Piston Shaft | 20 | 20 | 20 | 20 | 22 (Revolving Opening Portions Damaged) |
| Piston Shaft of Present Invention | 20 | 20 | 20 | 22 (Packing Replaced) | ----- |

### [Observation]

(1) As described in table 1, it was observed that in the case of employing the fixing screw 43a (see FIG. 10(A)), the packing needed to be replaced after 200 hours due to gas leakage.
(2) As described in table 1, it was observed that in the case of employing the conventional piston shaft 43b (see FIG. 10(C)), the distal end of the piston shaft 43b projected to the gas control sliding contact surface of the rotary ring unit 21 after 5000 hours, thereby damaging the revolving opening portions 23a of the rotary ring unit 21.
(3) As described in table 1, it was observed that in the case of employing the piston shaft 91 of the present invention (see FIG. 11(A)), the revolving opening portions 23a of the rotary ring unit 21 were not damaged and also the packing replacement timing could be managed after 4200 hours by detecting gas leakage.

### POSSIBILITY OF INDUSTRIAL APPLICATION

The can roll with a gas discharge mechanism according to the present invention can avoid gas leakage at the non-wrapped portion and damage of the revolving opening portions of the rotary ring unit. The present invention therefore is industrially applicable as a manufacturing apparatus and manufacturing method for copper-laminated resin films (metal film-coated heat-resistant resin films) for use as flexible wiring substrates in liquid crystal televisions, mobile phones, and so on.

### REFERENCE SIGNS LIST

α clearance space
10 cylindrical member
11 coolant circulation portion
12 rotary shaft
12a inner pipe
12b outer pipe
14 gas introduction channel
15 gas discharge hole
20 rotary joint
21 rotary ring unit
21a cylindrical base part
21b cylindrical protruding part
22 fixed ring unit
23 gas supply channel
23a revolving opening portion
23a1 revolving opening portion (corresponding to non-wrapped portion region)
23a2 revolving opening portion (corresponding to wrapped portion region)
25 connection pipe
26 supply pipe
27 gas distribution channel
27a annular recessed groove
32 bearing
40 cooling water inlet
41 fixing member
42 arched packing member
42a insertion hole
43 packing attachment member
43a fixing screw
43b piston shaft
44 gas introduction channel
50 vacuum chamber
51 unwinding roller
52 long heat-resistant resin film (long substrate)
53, 63 free roller
54, 62 tension sensor roll
55, 61 feed roller
56 can roll
56a center axis
57, 58, 59, 60 magnetron sputtering cathode
64 winding roll
77 fixing screw hole in rotary ring unit
82 pressure gauge port
83 pressure gauge port
90 tubular main body
91 piston shaft
92 flange portion
93 biasing means (coil spring)
100 attachment member housing portion

## Claims

1. A can roll (56) that comprises a coolant circulation portion (11) in which a coolant circulates, a plurality of gas introduction channels (14) arranged over an entire circumference of the can roll (56) at substantially equal intervals in a circumferential direction, and a rotary joint (20) which supplies a gas from outside a vacuum chamber (50) to each of the plurality of gas introduction channels (14), and that cools a long substrate (52) transferred through the vacuum chamber (50) in a roll-to-roll manner by having the long substrate (52) wrapped on part of an outer peripheral surface of the can roll (56), wherein
each of the plurality of gas introduction channels (14) comprises a plurality of gas discharge holes (15) opening toward the outer peripheral surface at substantially equal intervals along a direction of a rotation axis of the can roll (56),
the can roll (56) is controlled such that the rotary joint (20) supplies the gas to the gas introduction channels (14) situated within an angular range within which the long substrate (52) is wrapped, and does not supply the gas to the gas introduction channels (14) not situated within the angular range within which the long substrate (52) is wrapped,
the rotary joint (20) comprises a rotary ring unit (21) and a fixed ring unit (22) provided coaxially with the can roll (56) and each comprising a gas control sliding contact surface formed perpendicularly to a center axis (56a) of the can roll (56),
the rotary ring unit (21) comprises a plurality of gas supply channels (23) communicating with the plurality of gas introduction channels (14), respectively, the plurality of gas supply channels (23) each comprising a revolving opening portion (23a) at the gas control sliding contact surface of the rotary ring unit (21), the revolving opening portion (23a) opening at an angular position corresponding to an angular position, on the outer peripheral surface of the can roll (56), of the gas introduction channel (14) communicating with the gas supply channel (23), and
the fixed ring unit (22) comprises a gas distribution channel (27) formed by an annular recessed groove (27a), comprising a fixed opening portion, and communicating with a gas supply pipe (26) outside the vacuum chamber (50), the annular recessed groove (27a) being provided in the gas control sliding contact surface of the fixed ring unit (22) so as to extend in the circumferential direction, the fixed opening portion opening within an angular range in a region on the gas control sliding contact surface of the fixed ring unit (22) which the revolving opening portions (23a) of the rotary ring unit (21) face, the angular range being a range within which the long substrate (52) is wrapped,
**characterized in that**
the gas distribution channel (27) further comprises a fixed closed portion, the fixed closed portion being a portion at which the gas control sliding contact surface of the fixed ring unit (22) is closed by an arched packing member (42) fitted in a predetermined region inside the annular recessed groove (27a), the fixed opening portion being a portion at which the gas control sliding contact surface is not closed,
the arched packing member (42), which is fitted in the predetermined region inside the annular recessed groove (27a), is attached so as to be in a state of being constantly biased toward the gas control sliding contact surface of the rotary ring unit (21) by a piston member of a packing attachment member (43) disposed on a back side of the arched packing member (42), and
a range of stroke of a piston shaft (91) of the piston member is restricted such that a distal end of the piston shaft (91) remains behind an opening plane of the annular recessed groove (27a).

2. A can roll (56) that comprises a coolant circulation portion (11) in which a coolant circulates, a plurality of gas introduction channels (14) arranged over an entire circumference of the can roll (56) at substantially equal intervals in a circumferential direction, and a rotary joint (20) which supplies a gas from outside a vacuum chamber (50) to each of the plurality of gas introduction channels (14), and that cools a long substrate (52) transferred through the vacuum chamber (50) in a roll-to-roll manner by having the long substrate (52) wrapped on part of an outer peripheral surface of the can roll (56), wherein
each of the plurality of gas introduction channels (14) comprises a plurality of gas discharge holes (15) opening toward the outer peripheral surface at substantially equal intervals along a direction of a rotation axis of the can roll (56), and
the can roll (56) is controlled such that the rotary joint (20) supplies the gas to the gas introduction channels (14) situated within an angular range within which the long substrate (52) is wrapped, and does not supply the gas to the gas introduction channels (14) not situated within the angular range within which the long substrate (52) is wrapped,
**characterized in that**
the rotary joint (20) comprises a rotary ring unit (21) having a T-shaped cross section and comprising a cylindrical base part (21a) and a cylindrical protruding part (21b) provided coaxially with the can roll (56), and a cylindrical fixed ring unit (22) in which the cylindrical protruding part (21b) of the rotary ring unit (21) is fitted such that the cylindrical protruding part (21b) and the fixed ring unit (22) each comprises a gas control sliding contact surface formed in parallel to a center axis (56a) of the can roll (56),
the rotary ring unit (21) comprises a plurality of gas supply channels (23) communicating with the plurality of gas introduction channels (14), respectively, the plurality of gas supply channels (23) each comprising a revolving opening portion (23a) at the gas control sliding contact surface of the cylindrical protruding part (21b) of the rotary ring unit (21), the revolving opening portion (23a) opening at an angular position corresponding to an angular position, on the outer peripheral surface of the can roll (56), of the gas introduction channel (14) communicating with the gas supply channel (23),
the fixed ring unit (22) comprises a gas distribution channel (27) formed by an annular recessed groove (27a), comprising a fixed closed portion and a fixed opening portion, and communicating with a gas supply pipe (26) outside the vacuum chamber (50), the annular recessed groove (27a) being provided in a cylindrical inner circumferential surface of the fixed ring unit (22) so as to extend in the circumferential direction, the fixed closed portion being a portion at which the gas control sliding contact surface of the fixed ring unit (22) is closed by an arched packing member (42) fitted in a predetermined region inside the annular recessed groove (27a), the fixed opening portion being a portion at which the gas control sliding contact surface is not closed, the fixed opening portion opening within an angular range in a region on the gas control sliding contact surface of the fixed ring unit (22) which the revolving opening portions (23a) of the cylindrical protruding part (21b) of the rotary ring unit (21) face, the angular range being a range within which the long substrate (52) is wrapped,
the arched packing member (42), which is fitted in the predetermined region inside the annular recessed groove (27a), is attached so as to be in a state of being constantly biased toward the gas control sliding contact surface of the rotary ring unit (21) by a piston member of a packing attachment member (43) disposed on a back side of the arched packing member (42), and
a range of stroke of a piston shaft (91) of the piston member is restricted such that a distal end of the piston shaft (91) remains behind an opening plane of the annular recessed groove (27a).

3. The can roll (56) according to claim 1 or 2, wherein the packing attachment member (43) comprises
a tubular main body (90) housed in an attachment member housing portion (100) provided behind the annular recessed groove (27a), in which the arched packing member (42) is fitted, being closed on one end side, and comprising a piston shaft (91) insertion hole portion on another end side,
the piston member, housed in the tubular main body (90) and comprising the piston shaft (91), which penetrates through the hole portion, and a flange portion (92) which is provided on a proximal end side of the piston shaft (91), and
biasing means (93) housed in the tubular main body (90) and biasing the piston shaft (91) toward the annular recessed groove (27a) via the flange portion (92) of the piston member,
wherein a distal end of the piston shaft (91) of the piston member is inserted into the arched packing member (42) from a back side of the arched packing member (42) through a hole portion provided in a bottom surface of the annular recessed groove (27a), and as the arched packing member (42) wears due to contact with the gas control sliding contact surface of the rotary ring unit (21), the flange portion (92) of the piston member gets locked to the hole portion of the tubular main body (90) to thereby restrict the range of stroke of the piston shaft (91).

4. The can roll (56) according to any one of claims 1 to 3, wherein the biasing means (93) for biasing the piston shaft (91) of the piston member toward the annular recessed groove (27a) comprises a spring member incorporated on a back side of a flange portion (92) in the piston member.

5. The can roll (56) according to claim 4, wherein the spring member is a coil spring.

6. The can roll (56) according to any one of claims 1 to 5, wherein the arched packing member (42) is made of a fluorine-based resin.

7. A long substrate treatment apparatus comprising:
a vacuum chamber (50);
a transfer mechanism that transfers a long substrate (52) through the vacuum chamber (50) in a roll-to-roll manner;
treatment means (57, 58, 59, 60) for performing a treatment that applies a thermal load on the long substrate (52); and
a can roll (56) that cools the long substrate (52) by having the long substrate (52) wrapped on part of an outer peripheral surface of the can roll (56) cooled by circulating coolant,
**characterized in that**
the can roll (56) is the can roll (56) according to any one of claims 1 to 6.

8. The long substrate treatment apparatus according to claim 7, wherein the treatment that applies a thermal load is a plasma treatment or an ion beam treatment.

9. The long substrate treatment apparatus according to claim 8, wherein a mechanism that performs the plasma treatment or the ion beam treatment faces a transfer path defined on the outer peripheral surface of the can roll (56).

10. The long substrate treatment apparatus according to claim 7, wherein the treatment that applies a thermal load is a vacuum deposition treatment.

11. The long substrate treatment apparatus according to claim 10, wherein the vacuum deposition treatment is a treatment with vacuum deposition means facing a transfer path defined on the outer peripheral surface of the can roll (56).

12. The long substrate treatment apparatus according to claim 11, wherein the vacuum deposition means is magnetron sputtering.

13. A method of managing the long substrate treatment apparatus according to any one of claims 7 to 12, wherein the method comprises managing timing for replacement of the arched packing member (42) based on a decrease in gas pressure inside the gas introduction channels (14) or an increase in introduced gas amount for maintaining a specified pressure inside the gas introduction channels (14).

## Patentansprüche

1. Dosenrolle (56), die einen Kühlmittelzirkulationsabschnitt (11), in dem ein Kühlmittel zirkuliert, eine Vielzahl von Gaseinleitungskanälen (14), die in einer Umfangsrichtung über einen Gesamtumfang der Dosenrolle (56) in im Wesentlichen gleichen Abständen angeordnet sind, und eine Drehverbindung (20), die jedem der Vielzahl von Gaseinleitungskanälen (14) ein Gas von außerhalb einer Vakuumkammer (50) zuführt, umfasst und die ein Langsubstrat (52) kühlt, das von Rolle zu Rolle durch die Vakuumkammer (50) transportiert wird, indem sie das Langsubstrat (52) auf einem Teil einer Außenumfangsfläche der Dosenrolle (56) aufgewickelt hat, wobei
jeder der Vielzahl von Gaseinleitungskanälen (14) eine Vielzahl von Gasausstoßlöchern (15) umfasst, die sich in im Wesentlichen gleichen Abständen entlang einer Richtung einer Drehachse der Dosenrolle (56) in Richtung der Außenumfangsfläche öffnen,
die Dosenrolle (56) derart gesteuert wird, dass die Drehverbindung (20) das Gas den Gaseinleitungskanälen (14) zuführt, die sich innerhalb eines Winkelbereichs befinden, innerhalb dessen das Langsubstrat (52) aufgewickelt ist, und das Gas nicht den Gaseinleitungskanälen (14) zuführt, die sich nicht innerhalb des Winkelbereichs befinden, innerhalb dessen das Langsubstrat (52) aufgewickelt ist,
die Drehverbindung (20) eine Drehringeinheit (21) und eine Festringeinheit (22) umfasst, die koaxial zur Dosenrolle (56) vorgesehen sind und jeweils eine Gassteuerungsgleitkontaktfläche umfassen, die senkrecht zu einer Mittelachse (56a) der Dosenrolle (56) ausgebildet ist,
die Drehringeinheit (21) eine Vielzahl von Gaszufuhrkanälen (23) umfasst, die jeweils mit der Vielzahl von Gaseinleitungskanälen (14) in Verbindung stehen, wobei die Vielzahl von Gaszufuhrkanälen (23) an der Gassteuerungsgleitkontakfläche der Drehringeinheit (21) jeweils einen umlaufenden sich öffnenden Abschnitt (23a) umfasst und sich der umlaufende sich öffnende Abschnitt (23a) an einer Winkelposition öffnet, die einer Winkelposition des mit dem Gaszufuhrkanal (23) in Verbindung stehenden Gaseinleitungskanals (14) auf der Außenumfangsfläche der Dosenrolle (56) entspricht, und
die Festringeinheit (22) einen Gasverteilungskanal (27) umfasst, der von einer ringförmigen vertieften Nut (27a) ausgebildet wird, der einen festen sich öffnenden Abschnitt umfasst und der mit einem Gaszufuhrrohr (26) außerhalb der Vakuumkammer (50) in Verbindung steht, wobei die ringförmige vertiefte Nut (27a) so in der Gassteuerungsgleitkontaktfläche der Festringeinheit (22) vorgesehen ist, dass sie sich in der Umfangsrichtung erstreckt, sich der feste sich öffnende Abschnitt in einem Bereich auf der Gassteuerungsgleitkontaktfläche der Festringeinheit (22) innerhalb eines Winkelbereichs öffnet, dem die umlaufenden sich öffnenden Abschnitte (23a) der Drehringeinheit (21) zugewandt sind, und der Winkelbereich ein Bereich ist, innerhalb dessen das Langsubstrat (52) aufgewickelt ist,
**dadurch gekennzeichnet, dass**
der Verteilungskanal (27) außerdem einen festen geschlossenen Abschnitt umfasst, wobei der feste geschlossene Abschnitt ein Abschnitt ist, an dem die Gassteuerungsgleitkontaktfläche der Festringeinheit (22) von einem bogenförmigen Dichtungselement (42) geschlossen wird, das in einem vorbestimmten Bereich innerhalb der ringförmigen vertieften Nut (27a) eingepasst ist, wobei der feste sich öffnende Abschnitt ein Abschnitt ist, an dem die Gassteuerungsgleitkontaktfläche nicht geschlossen ist,
das bogenförmige Dichtungselement (42), das in dem vorbestimmten Bereich innerhalb der ringförmigen vertieften Nut (27a) eingepasst ist, so angebracht ist, dass es sich in einem Zustand befindet, in dem es durch ein Kolbenelement eines Dichtungsanbringungselements (43), das auf einer Rückseite des bogenförmigen Dichtungselements (42) angeordnet ist, ständig in Richtung der Gassteuerungsgleitkontaktfläche der Drehringeinheit (21) vorgespannt wird, und
ein Hubbereich eines Kolbenschafts (91) des Kolbenelements derart eingeschränkt ist, dass ein fernes Ende des Kolbenschafts (91) hinter einer Öffnungsebene der ringförmigen vertieften Nut (27a) bleibt.

2. Dosenrolle (56), die einen Kühlmittelzirkulationsabschnitt (11), in dem ein Kühlmittel zirkuliert, eine Vielzahl von Gaseinleitungskanälen (14), die in einer Umfangsrichtung über einen Gesamtumfang der Dosenrolle (56) in im Wesentlichen gleichen Abständen angeordnet sind, und eine Drehverbindung (20), die jedem der Vielzahl von Gaseinleitungskanälen (14) ein Gas von außerhalb einer Vakuumkammer (50) zuführt, umfasst und die ein Langsubstrat (52) kühlt, das von Rolle zu Rolle durch die Vakuumkammer (50) transportiert wird, indem sie das Langsubstrat (52) auf einem Teil einer Außenumfangsfläche der Dosenrolle (56) aufgewickelt hat, wobei
jeder der Vielzahl von Gaseinleitungskanälen (14) eine Vielzahl von Gasausstoßlöchern (15) umfasst, die sich in im Wesentlichen gleichen Abständen entlang einer Richtung einer Drehachse der Dosenrolle (56) in Richtung der Außenumfangsfläche öffnen, und
die Dosenrolle (56) derart gesteuert wird, dass die Drehverbindung (20) das Gas den Gaseinleitungskanälen (14) zuführt, die sich innerhalb eines Winkelbereichs befinden, innerhalb dessen das Langsubstrat (52) aufgewickelt ist, und das Gas nicht den Gaseinleitungskanälen (14) zuführt, die sich nicht innerhalb des Winkelbereichs befinden, innerhalb dessen das Langsubstrat (52) aufgewickelt ist,
**dadurch gekennzeichnet, dass**
die Drehverbindung (20) eine Drehringeinheit (21), die einen T-förmigen Querschnitt hat und die einen zylindrischen Grundteil (21a) und einen zylindrischen vorstehenden Teil (21b) umfasst, die koaxial zur Dosenrolle (56) vorgesehen sind, und eine zylindrische Festringeinheit (22) umfasst, in der der zylindrische vorstehende Teil (21b) der Drehringeinheit (21) derart eingepasst ist, dass der zylindrische vorstehende Teil (21b) und die Festringeinheit (22) jeweils eine Gassteuerungsgleitkontaktfläche umfassen, die parallel zu einer Mittelachse (56a) der Dosenrolle (56) ausgebildet ist,
die Drehringeinheit (21) eine Vielzahl von Gaszufuhrkanälen (23) umfasst, die jeweils mit der Vielzahl von Gaseinleitungskanälen (14) in Verbindung stehen, wobei die Vielzahl von Gaszufuhrkanälen (23) an der Gassteuerungsgleitkontaktfläche des zylindrischen vorstehenden Teils (21b) der Drehringeinheit (21) jeweils einen umlaufenden sich öffnenden Abschnitt (23a) umfasst und sich der umlaufende sich öffnende Abschnitt (23a) an einer Winkelposition öffnet, die einer Winkelposition des mit dem Gaszuführungskanal (23) in Verbindung stehenden Gaseinleitungskanals (14) auf der Außenumfangsfläche der Dosenrolle (56) entspricht,
die Festringeinheit (22) einen Gasverteilungskanal (27) umfasst, der von einer ringförmigen vertieften Nut (27a) ausgebildet wird, der einen festen geschlossenen Abschnitt und einen festen sich öffnenden Abschnitt umfasst und der mit einem Gaszufuhrrohr (26) außerhalb der Vakuumkammer (50) in Verbindung steht, wobei die ringförmige vertiefte Nut (27a) so in einer zylindrischen Innenumfangsfläche der Festringeinheit (22) vorgesehen ist, dass sie sich in der Umfangsrichtung erstreckt, der feste geschlossene Abschnitt ein Abschnitt ist, an dem die Gassteuerungsgleitkontaktfläche der Festringeinheit (22) von einem bogenförmigen Dichtungselement (42) geschlossen wird, das in einem vorbestimmten Bereich innerhalb der ringförmigen vertieften Nut (27a) eingepasst ist, der feste sich öffnende Abschnitt ein Abschnitt ist, an dem die Gassteuerungsgleitkontaktfläche nicht geschlossen ist, sich der feste sich öffnende Abschnitt in einem Bereich auf der Gassteuerungsgleitkontaktfläche der Festringeinheit (22) innerhalb eines Winkelbereichs öffnet, dem die umlaufenden sich öffnenden Abschnitte (23a) des zylindrischen vorstehenden Teils (21b) der Drehringeinheit (21) zugewandt sind, und der Winkelbereich ein Bereich ist, innerhalb dessen das Langsubstrat (52) aufgewickelt ist,
das bogenförmige Dichtungselement (42), das in dem vorbestimmten Bereich innerhalb der ringförmigen vertieften Nut (27a) eingepasst ist, so angebracht ist, dass es sich in einem Zustand befindet, in dem es durch ein Kolbenelement eines Dichtungsanbringungselements (43), das auf einer Rückseite des bogenförmigen Dichtungselements (42) angeordnet ist, ständig in Richtung der Gassteuerungsgleitkontaktfläche vorgespannt wird, und
ein Hubbereich eines Kolbenschafts (91) des Kolbenelements derart eingeschränkt ist, dass ein fernes Ende des Kolbenschafts (21) hinter einer Öffnungsebene der ringförmigen vertieften Nut (27a) bleibt.

3. Dosenrolle (56) nach Anspruch 1 oder 2, wobei das Dichtungsanbringungselement (43) Folgendes umfasst:
einen rohrförmigen Hauptkörper (90), der in einem Anbringungselement-Unterbringungsabschnitt (100) untergebracht ist, der hinter der ringförmigen vertieften Nut (27a) angeordnet ist, in der das bogenförmige Dichtungselement (42) eingepasst ist, der auf einer Endseite geschlossen ist und der auf einer anderen Endseite einen Einführlochabschnitt für den Kolbenschaft (91) umfasst,
das Kolbenelement, das in dem rohrförmigen Hauptkörper (90) untergebracht ist und das den Kolbenschaft (91), der den Lochabschnitt durchdringt, und einen Flanschabschnitt (92) umfasst, der auf einer nahen Endseite des Kolbenschafts (91) vorgesehen ist, und
Vorspannmittel (93), die in dem rohrförmigen Hauptkörper (90) untergebracht sind und die den Kolbenschaft (91) über den Flanschabschnitt (92) des Kolbenelements in Richtung der ringförmigen vertieften Nut (27a) vorspannen,
wobei ein fernes Ende des Kolbenschafts (91) des Kolbenelements von einer Rückseite des bogenförmigen Dichtungselements (42) aus durch einen Lochabschnitt, der in einer Bodenfläche der ringförmigen vertieften Nut (27a) vorgesehen ist, in das bogenförmige Dichtungselement (42) eingeführt ist, und der Flanschabschnitt (92) des Kolbenelements mit Abnutzung des bogenförmigen Dichtungselements (42) aufgrund von Kontakt mit der Gassteuerungsgleitkontaktfläche der Drehringeinheit (21) mit dem Lochabschnitt des rohrförmigen Hauptkörpers (20) verriegelt wird, um dadurch den Hubbereich des Kolbenschafts (91) einzuschränken.

4. Dosenrolle (56) nach einem der Ansprüche 1 bis 3, wobei die Vorspannmittel (93) zum Vorspannen des Kolbenschafts (91) des Kolbenelements in Richtung der ringförmigen vertieften Nut (27a) ein Federelement umfassen, das auf einer Rückseite eines Flanschabschnitts (92) in dem Kolbenelement eingebaut ist.

5. Dosenrolle (56) nach Anspruch 4, wobei das Federelement eine Spiralfeder ist.

6. Dosenrolle (56) nach einem der Ansprüche 1 bis 5, wobei das bogenförmige Dichtungselement (42) aus einem Harz auf Fluorbasis besteht.

7. Langsubstrat-Behandlungsvorrichtung, die Folgendes umfasst:
eine Vakuumkammer (50);
einen Transportmechanismus, der ein Langsubstrat (52) von Rolle zu Rolle durch die Vakuumkammer (50) transportiert;
Behandlungsmittel (57, 58, 59, 60) zur Durchführung einer Behandlung, die auf das Langsubstrat (52) eine Wärmelast aufbringt; und
eine Dosenrolle (56), die das Langsubstrat (52) kühlt, indem sie das Langsubstrat (52) auf einem Teil einer Außenumfangsfläche der Dosenrolle (56) aufgewickelt hat, die durch zirkulierendes Kühlmittel gekühlt wird,
**dadurch gekennzeichnet, dass**
die Dosenrolle (56) die Dosenrolle (56) nach einem der Ansprüche 1 bis 6 ist.

8. Langsubstrat-Behandlungsvorrichtung nach Anspruch 7, wobei die Behandlung, die eine Wärmelast aufbringt, eine Plasmabehandlung oder eine Ionenstrahlbehandlung ist.

9. Langsubstrat-Behandlungsvorrichtung nach Anspruch 8, wobei ein Mechanismus, der die Plasmabehandlung oder die Ionenstrahlbehandlung durchführt, einem Transportweg zugewandt ist, der auf der Außenumfangsfläche der Dosenrolle (56) definiert ist.

10. Langsubstrat-Behandlungsvorrichtung nach Anspruch 7, wobei die Behandlung, die eine Wärmelast aufbringt, eine Vakuumabscheidungsbehandlung ist.

11. Langsubstrat-Behandlungsvorrichtung nach Anspruch 10, wobei die Vakuumabscheidungsbehandlung eine Behandlung mit Vakuumabscheidungsmitteln ist, die einem Transportweg zugewandt sind, der auf der Außenumfangsfläche der Dosenrolle (56) definiert ist.

12. Langsubstrat-Behandlungsvorrichtung nach Anspruch 11, wobei die Vakuumabscheidungsmittel Magnetron-Sputtern sind.

13. Verfahren zur Verwaltung der Langsubstrat-Behandlungsvorrichtung nach einem der Ansprüche 7 bis 12, wobei das Verfahren die Verwaltung eines Zeitplans zum Austausch des bogenförmigen Dichtungselements (42) beruhend auf einer Abnahme eines Gasdrucks innerhalb der Gaseinleitungskanäle (14) oder einer Erhöhung einer eingeleiteten Gasmenge zum Aufrechterhalten eines bestimmten Drucks innerhalb der Gaseinleitungskanäle (14) umfasst.

## Revendications

1. Rouleau scellé (56) qui comprend une partie de circulation de liquide de refroidissement (11) dans laquelle circule un liquide de refroidissement, une pluralité de canaux d'introduction de gaz (14) agencés sur toute une circonférence du rouleau scellé (56) à des intervalles sensiblement égaux dans une direction circonférentielle, et un joint rotatif (20) qui alimente un gaz de l'extérieur d'une chambre à vide (50) à chacun de la pluralité des canaux d'introduction de gaz (14), et qui refroidit un long substrat (52) transféré de rouleau à rouleau à travers la chambre à vide (50) en enveloppant le long substrat (52) sur une partie d'une surface périphérique extérieure du rouleau scellé (56), dans lequel
chacun de la pluralité de canaux d'introduction de gaz (14) comprend une pluralité de trous de décharge de gaz (15) s'ouvrant vers la surface périphérique extérieure à des intervalles sensiblement égaux le long d'une direction d'un axe de rotation du rouleau scellé (56),
le rouleau scellé (56) est commandé de telle sorte que le joint rotatif (20) alimente le gaz aux canaux d'introduction de gaz (14) situés dans une plage angulaire dans laquelle le long substrat (52) est enveloppé, et n'alimente pas un gaz aux canaux d'introduction de gaz (14) qui ne sont pas situés dans la plage angulaire dans laquelle le long substrat (52) est enveloppé,
le joint rotatif (20) comprend une unité de bague rotative (21) et une unité de bague fixe (22) prévues coaxialement avec le rouleau scellé (56) et comprenant chacune une surface de contact de coulissement de commande de gaz formée perpendiculairement à un axe central (56a) du rouleau scellé (56),
l'unité de bague rotative (21) comprend une pluralité de canaux d'alimentation en gaz (23) communiquant avec la pluralité de canaux d'introduction de gaz (14), respectivement, la pluralité de canaux d'alimentation en gaz (23) comprenant chacun une partie d'ouverture tournante (23a) sur la surface de contact de coulissement de commande de gaz de l'unité de bague rotative (21), la partie d'ouverture tournante (23a) s'ouvrant à une position angulaire correspondant à une position angulaire, sur la surface périphérique extérieure du rouleau scellé (56), du canal d'introduction de gaz (14) communiquant avec le canal d'alimentation en gaz (23), et
l'unité de bague fixe (22) comprend un canal de distribution de gaz (27) formé par une rainure annulaire en creux (27a), comprenant une partie d'ouverture fixe, et communiquant avec un tuyau d'alimentation en gaz (26) à l'extérieur de la chambre à vide (50), la rainure annulaire en creux (27a) étant prévue dans la surface de contact de coulissement de commande de gaz de l'unité de bague fixe (22) de manière à s'étendre dans la direction circonférentielle, la partie d'ouverture fixe s'ouvrant dans une plage angulaire dans une région sur la surface de contact de coulissement de commande de gaz de l'unité de bague fixe (22) à laquelle font face les parties d'ouverture tournantes (23a) de l'unité de bague rotative (21), la plage angulaire étant une plage dans laquelle le long substrat (52) est enveloppé,
**caractérisé en ce que**
le canal de distribution de gaz (27) comprend en outre une partie fermée fixe, la partie fermée fixe étant une partie au niveau de laquelle la surface de contact de coulissement de commande de gaz de l'unité de bague fixe (22) est fermée par un élément de garniture arqué (42) ajusté dans une région prédéterminée à l'intérieur de la rainure annulaire en creux (27a), la partie d'ouverture fixe étant une partie au niveau de laquelle la surface de contact de coulissement de commande de gaz n'est pas fermée,
l'élément de garniture arqué (42), qui est ajusté dans la région prédéterminée à l'intérieur de la rainure annulaire en creux (27a), est fixé de manière à être constamment sollicité vers la surface de contact de coulissement de commande de gaz de l'unité de bague rotative (21) par un élément de piston d'un élément de fixation de garniture (43) disposé sur un côté arrière de l'élément de garniture arqué (42), et
une plage de course d'un arbre de piston (91) de l'élément de piston est limitée de telle sorte qu'une extrémité distale de l'arbre de piston (91) reste derrière un plan d'ouverture de la rainure annulaire en creux (27a).

2. Rouleau scellé (56) qui comprend une partie de circulation de liquide de refroidissement (11) dans laquelle circule un liquide de refroidissement, une pluralité de canaux d'introduction de gaz (14) agencés sur toute une circonférence du rouleau scellé (56) à des intervalles sensiblement égaux dans une direction circonférentielle, et un joint rotatif (20) qui alimente un gaz de l'extérieur d'une chambre à vide (50) à chacun de la pluralité des canaux d'introduction de gaz (14), et qui refroidit un long substrat (52) transféré de rouleau à rouleau à travers la chambre à vide (50) en enveloppant le long substrat (52) sur une partie d'une surface périphérique extérieure du rouleau scellé (56), dans lequel
chacun de la pluralité de canaux d'introduction de gaz (14) comprend une pluralité de trous de décharge de gaz (15) s'ouvrant vers la surface périphérique extérieure à des intervalles sensiblement égaux le long d'une direction d'un axe de rotation du rouleau scellé (56), et
le rouleau scellé (56) est commandé de telle sorte que le joint rotatif (20) alimente le gaz aux canaux d'introduction de gaz (14) situés dans une plage angulaire dans laquelle le long substrat (52) est enveloppé, et n'alimente pas un gaz aux canaux d'introduction de gaz (14) qui ne sont pas situés dans la plage angulaire dans laquelle le long substrat (52) est enveloppé,
**caractérisé en ce que**
le joint rotatif (20) comprend une unité de bague rotative (21) ayant une section transversale en forme de T et comprenant une pièce de base cylindrique (21a) et une pièce cylindrique saillante (21b) prévues coaxialement avec le rouleau scellé (56), et une unité de bague fixe (22) cylindrique dans laquelle la pièce cylindrique saillante (21b) de l'unité de bague rotative (21) est ajustée de sorte que la pièce cylindrique saillante (21b) et l'unité de bague fixe (22) comprennent chacune une surface de contact de coulissement de commande de gaz formée parallèlement à un axe central (56a) du rouleau scellé (56),
l'unité de bague rotative (21) comprend une pluralité de canaux d'alimentation en gaz (23) communiquant avec la pluralité de canaux d'introduction de gaz (14), respectivement, la pluralité de canaux d'alimentation en gaz (23) comprenant chacun une partie d'ouverture tournante (23a) sur la surface de contact de coulissement de commande de gaz de la pièce cylindrique saillante (21b) de l'unité de bague rotative (21), la partie d'ouverture tournante (23a) s'ouvrant à une position angulaire correspondant à une position angulaire, sur la surface périphérique extérieure du rouleau scellé (56), du canal d'introduction de gaz (14) communiquant avec le canal d'alimentation en gaz (23),
l'unité de bague fixe (22) comprend un canal de distribution de gaz (27) formé par une rainure annulaire en creux (27a), comprenant une partie fermée fixe et une partie d'ouverture fixe, et communiquant avec un tuyau d'alimentation en gaz (26) à l'extérieur de la chambre à vide (50), la rainure annulaire en creux (27a) est prévue dans une surface circonférentielle intérieure cylindrique de l'unité de bague fixe (22), de manière à s'étendre dans la direction circonférentielle, la partie fermée fixe étant une partie au niveau de laquelle la surface de contact de coulissement de commande de gaz de l'unité de bague fixe (22) est fermée par un élément de garniture arqué (42) ajusté dans une région prédéterminée à l'intérieur de la rainure annulaire en creux (27a), la partie d'ouverture fixe étant une partie au niveau de laquelle la surface de contact de coulissement de commande de gaz n'est pas fermée, la partie d'ouverture fixe s'ouvrant dans une plage angulaire dans une région sur la surface de contact de coulissement de commande de gaz de l'unité de bague fixe (22) à laquelle font face les parties d'ouverture tournantes (23a) de la pièce cylindrique saillante (21b) de l'unité de bague rotative (21), la plage angulaire étant une plage dans laquelle le long substrat (52) est enveloppé,
l'élément de garniture arqué (42), qui est ajusté dans la région prédéterminée à l'intérieur de la rainure annulaire en creux (27a), est fixé de manière à être constamment sollicité vers la surface de contact de coulissement de commande de gaz de l'unité de bague rotative (21) par un élément de piston d'un élément de fixation de garniture (43) disposé sur un côté arrière de l'élément de garniture arqué (42), et
une plage de course d'un arbre de piston (91) de l'élément de piston est limitée de telle sorte qu'une extrémité distale de l'arbre de piston (91) reste derrière un plan d'ouverture de la rainure annulaire en creux (27a).

3. Rouleau scellé (56) selon la revendication 1 ou 2, dans lequel l'élément de fixation de garniture (43) comprend
un corps principal tubulaire (90) logé dans une partie de logement de l'élément de fixation (100) prévue derrière la rainure annulaire en creux (27a), dans laquelle l'élément de garniture arqué (42) est ajusté, étant fermé d'un côté d'extrémité et comprenant une partie de trou d'insertion de l'arbre de piston (91) d'un autre côté d'extrémité,
l'élément de piston, logé dans le corps principal tubulaire (90) et comprenant l'arbre de piston (91), qui pénètre à travers la partie de trou, et une partie bride (92) qui est prévue sur un côté d'extrémité proximale de l'arbre de piston (91), et
un moyen de sollicitation (93) logés dans le corps principal tubulaire (90) et sollicitant l'arbre du piston (91) vers la rainure annulaire en creux (27a) via la partie bride (92) de l'élément de piston,
dans lequel une extrémité distale de l'arbre de piston (91) de l'élément de piston est insérée dans l'élément de garniture arqué (42) à partir d'un côté arrière de l'élément de garniture arqué (42) à travers une partie de trou prévue dans une surface inférieure de la rainure annulaire en creux (27a), et lorsque l'élément de garniture arqué (42) s'use en raison du contact avec la surface de contact de coulissement de commande de gaz de l'unité de bague rotative (21), la partie bride (92) de l'élément de piston se verrouille sur la partie de trou du corps principal tubulaire (90) pour limiter ainsi la plage de course de l'arbre de piston (91).

4. Rouleau scellé (56) selon l'une des revendications 1 à 3, dans lequel le moyen de sollicitation (93) pour solliciter l'arbre de piston (91) de l'élément de piston vers la rainure annulaire en creux (27a) comprend un élément de ressort incorporé sur un côté arrière d'une partie bride (92) dans l'élément de piston.

5. Rouleau scellé (56) selon la revendication 4, dans lequel l'élément de ressort est un ressort hélicoïdal.

6. Rouleau scellé (56) selon l'une des revendications 1 à 5, dans lequel l'élément de garniture arqué (42) est constitué d'une résine à base de fluor.

7. Appareil de traitement de long substrat comprenant :
une chambre à vide (50) ;
un mécanisme de transfert qui transfère de rouleau à rouleau un long substrat (52) à travers la chambre à vide (50) ;
un moyen de traitement (57, 58, 59, 60) pour effectuer un traitement qui applique une charge thermique au long substrat (52) ; et
un rouleau scellé (56) qui refroidit le long substrat (52) en enveloppant le long substrat sur une partie d'une surface périphérique extérieure du rouleau scellé (56) refroidie par la circulation d'un liquide de refroidissement,
**caractérisé en ce que**
le rouleau scellé (56) est le rouleau scellé (56) selon l'une des revendications 1 à 6.

8. Appareil de traitement de long substrat selon la revendication 7, dans lequel le traitement qui applique une charge thermique est un traitement au plasma ou un traitement par faisceau ionique.

9. Appareil de traitement de long substrat selon la revendication 8, dans lequel un mécanisme qui effectue le traitement au plasma ou le traitement par faisceau ionique fait face à un chemin de transfert défini sur la surface périphérique extérieure du rouleau scellé (56).

10. Appareil de traitement de long substrat selon la revendication 7, dans lequel le traitement qui applique une charge thermique est un traitement de dépôt sous vide.

11. Appareil de traitement de long substrat selon la revendication 10, dans lequel le traitement de dépôt sous vide est un traitement avec un moyen de dépôt sous vide faisant face à un chemin de transfert défini sur la surface périphérique extérieure du rouleau scellé (56).

12. Appareil de traitement de long substrat selon la revendication 11, dans lequel le moyen de dépôt sous vide est la pulvérisation magnétron.

13. Procédé de gestion de l'appareil de traitement de long substrat selon l'une des revendications 7 à 12, dans lequel le procédé comprend la gestion du temps de remplacement de l'élément de garniture arqué (42) sur la base d'une diminution de la pression de gaz à l'intérieur des canaux d'introduction de gaz (14) ou d'une augmentation de la quantité de gaz introduite pour maintenir une pression spécifiée à l'intérieur des canaux d'introduction de gaz (14).
